# EUROPÄISCHE PATENTSCHRIFT

(11) **EP 3 212 728 B1**
(45) Veröffentlichungstag und Bekanntmachung des Hinweises auf die Patenterteilung: **03.10.2018**
(21) Anmeldenummer: 15786882.9
(22) Anmeldetag: 15.10.2015
(51) Int. Cl.: C09J 153/02, C08L 83/06, C08L 91/00, C09J 11/08, C09J 11/06, H01L 23/26, H01L 51/52, C08K 5/1515, C08K 5/5425, C08K 5/5435, H01L 51/00, H01L 51/56

(54) **KLEBEMASSEN MIT MULTIFUNKTIONELLEN SILOXANWASSERFÄNGERN**
ADHESIVE COMPOUNDS COMPRISING MULTI-FUNCTIONAL SILOXANE WATER SCAVENGERS
MATIÈRES ADHÉSIVES DOTÉES DE SILOXANES MULTIFONCTIONNELS CAPTANT L'EAU

(30) Priorität: 29.10.2014 DE 102014222025
(43) Veröffentlichungstag der Anmeldung: 06.09.2017
(73) Patentinhaber: tesa SE, 22848 Norderstedt (DE)
(72) Erfinder: SCHUH, Christian, 22767 Hamburg (DE); KEITE-TELGENBÜSCHER, Klaus, 22529 Hamburg (DE)
(86) Internationale Anmeldenummer: PCT/EP2015/073904
(87) Internationale Veröffentlichungsnummer: WO 2016/066437

(56) Entgegenhaltungen:
- WO-A1-2013/165010
- DE-A1-102012 202 377

## Beschreibung

Die vorliegende Erfindung betrifft eine wasserdampfsperrende Klebemasse für die Kapselung einer (opto-)elektronischen Anordnung, enthaltend mindestens ein Reaktivharz, mindestens ein Polymer, insbesondere einem Elastomer, optional ein Klebharz, optional ein Lösungsmittel. Des Weiteren betrifft die Erfindung ein Klebeband mit dieser Klebemasse sowie die Verwendung einer solchen Klebemasse.

(Opto-)elektronische Anordnungen werden immer häufiger in kommerziellen Produkten verwendet. Derartige Anordnungen umfassen anorganische oder organische elektronische Strukturen, beispielsweise organische, metallorganische oder polymere Halbleiter oder auch Kombinationen dieser. Diese Anordnungen und Produkte sind je nach gewünschter Anwendung starr oder flexibel ausgebildet, wobei eine zunehmende Nachfrage nach flexiblen Anordnungen besteht. Die Herstellung derartiger Anordnungen erfolgt beispielsweise durch Druckverfahren wie Hochdruck, Tiefdruck, Siebdruck, Flachdruck oder wie auch so genanntes "non impact printing" wie etwa Thermotransferdruck Tintenstrahldruck oder Digitaldruck. Vielfach werden aber auch Vakuumverfahren wie zum Beispiel Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung verwendet, wobei die Strukturierung in der Regel durch Masken erfolgt.

Als Beispiele für bereits kommerzielle oder in ihrem Marktpotential interessante (opto- )elektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, Elektrolumineszenzlampen, lichtemittierende elektrochemische Zellen (LEECs), organische Solarzellen, bevorzugt Farbstoff- oder Polymersolarzellen, anorganische Solarzellen, bevorzugt Dünnschichtsolarzellen, insbesondere auf der Basis von Silizium, Germanium, Kupfer, Indium und Selen, Perowskitsolarzellen, organische Feldeffekt-Transistoren, organische Schaltelemente, organische optische Verstärker, organische Laserdioden, organische oder anorganische Sensoren oder auch organisch- oder anorganischbasierte RFID-Transponder angeführt.

Weitere Anwendungen verkapselnder Klebebänder sind im Bereich der Batterietechnik bekannt, insbesondere im Bereich der flexiblen Mikrobatterien und Dünnschichtbatterien, ganz besonders solchen umfassend lithiumhaltige Kathoden, Anoden oder Elektrolyte.

Demgemäß wird in dieser Schrift unter einer organischen (opto-)elektronischen Anordnung eine elektronische Anordnung verstanden, die zumindest einen elektronisch funktionalen, zumindest teilweise organischen Bestandteil umfasst - zum Beispiel metallorganische Verbindungen - oder deren elektronisch funktionaler Aufbau eine Dicke von weniger als 20 µm aufweist.

Als technische Herausforderung für die Realisierung ausreichender Lebensdauer und Funktion von (opto-)elektronischen Anordnungen im Bereich der anorganischen und/oder organischen (Opto-)Elektronik, ganz besonders aber im Bereich der organischen (Opto- )Elektronik ist ein Schutz der darin enthaltenen Komponenten vor Permeaten zu sehen. Permeat können eine Vielzahl von niedermolekularen organischen oder anorganischen Verbindungen sein, insbesondere Wasserdampf und Sauerstoff.

Eine Vielzahl von (opto-)elektronischen Anordnungen im Bereich der anorganischen und/oder organischen (Opto-)Elektronik, ganz besonders bei Verwendung von organischen Rohstoffen, ist sowohl gegen Wasserdampf als auch gegen Sauerstoff empfindlich, wobei für viele Anordnungen das Eindringen von Wasser oder Wasserdampf als größeres Problem eingestuft wird. Während der Lebensdauer der elektronischen Anordnung ist deshalb ein Schutz durch eine Verkapselung erforderlich, da andernfalls die Leistung über den Anwendungszeitraum nachlässt. So können sich beispielsweise durch eine Oxidation der Bestandteile etwa bei lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Bei der anorganischen und/oder organischen (Opto-)Elektronik, insbesondere bei der organischen (Opto-)Elektronik, gibt es besonderen Bedarf für flexible Klebelösungen, die eine Permeationsbarriere für Permeate wie Sauerstoff und/oder Wasserdampf darstellen.

Daneben gibt es eine Vielzahl von weiteren Anforderungen für derartige (opto)-elektronische Anordnungen. Die flexiblen Klebelösungen sollen daher nicht nur eine gute Haftung zwischen zwei Substraten erzielen, sondern zusätzlich Eigenschaften wie hohe Scherfestigkeit und Schälfestigkeit, chemische Beständigkeit, Alterungsbeständigkeit, hohe Transparenz, einfache Prozessierbarkeit sowie hohe Flexibilität und Biegsamkeit erfüllen.

Ein nach dem Stand der Technik gängiger Ansatz ist deshalb, die elektronische Anordnung zwischen zwei für Wasserdampf und Sauerstoff undurchlässige Substrate zu legen. Anschließend erfolgt dann eine Versiegelung an den Rändern. Für unflexible Aufbauten werden Glas oder Metallsubstrate verwendet, die eine hohe Permeationsbarriere bieten, aber sehr anfällig für mechanische Belastungen sind. Ferner verursachen diese Substrate eine relativ große Dicke der gesamten Anordnung. Im Falle von Metallsubstraten besteht zudem keine Transparenz. Für flexible Anordnungen hingegen kommen Flächensubstrate wie transparente oder nicht transparente Folien zum Einsatz, die mehrlagig ausgeführt sein können. Hierbei können sowohl Kombinationen aus verschieden Polymeren, als auch anorganische oder organische Schichten verwendet werden. Der Einsatz solcher Flächensubstrate ermöglicht einen flexiblen, äußerst dünnen Aufbau. Dabei sind für die verschiedenen Anwendungen unterschiedlichste Substrate wie zum Beispiel Folien, Gewebe, Vliese und Papiere oder Kombinationen daraus möglich.

Um eine möglichst gute Versiegelung zu erzielen, werden spezielle Barriereklebemassen (auch als wasserdampfsperrende Klebemassen bezeichnet) verwendet. Eine gute Klebemasse für die Versiegelung von (opto-)elektronischen Bauteilen weist eine geringe Permeabilität gegen Sauerstoff und insbesondere gegen Wasserdampf auf, hat eine ausreichende Haftung auf der Anordnung und kann gut auf diese auffließen. Eine geringe Haftung auf der Anordnung verringert die Barrierewirkung an der Grenzfläche, wodurch ein Eintritt von Sauerstoff und Wasserdampf unabhängig von den Eigenschaften der Klebmasse ermöglicht wird. Nur wenn der Kontakt zwischen Masse und Substrat durchgängig ist, sind die Masseeigenschaften der bestimmende Faktor für die Barrierewirkung der Klebemasse.

Zur Charakterisierung der Barrierewirkung werden üblicherweise die Sauerstofftransmissionsrate OTR (Oxygen Transmission Rate) sowie die Wasserdampftransmissionsrate WVTR (Water Vapor Transmission Rate) angegeben. Die jeweilige Rate gibt dabei den flächen- und zeitbezogenen Fluss von Sauerstoff beziehungsweise Wasserdampf durch einen Film unter spezifischen Bedingungen von Temperatur und Partialdruck sowie gegebenenfalls weiterer Messbedingungen wie relativer Luftfeuchtigkeit an. Je geringer diese Werte sind, desto besser ist das jeweilige Material zur Kapselung geeignet. Die Angabe der Permeation basiert dabei nicht allein auf den Werten für WVTR oder OTR, sondern beinhaltet immer auch eine Angabe zur mittleren Weglänge der Permeation wie zum Beispiel die Dicke des Materials oder eine Normalisierung auf eine bestimmte Weglänge.

Die Permeabilität P ist ein Maß für die Durchlässigkeit eines Körpers für Gase und/oder Flüssigkeiten. Ein niedriger P-Wert kennzeichnet eine gute Barrierewirkung. Die Permeabilität P ist ein spezifischer Wert für ein definiertes Material und einen definierten Permeaten unter stationären Bedingungen bei bestimmter Permeationsweglänge, Partialdruck und Temperatur. Die Permeabilität P ist das Produkt aus Diffusions-Term D und Löslichkeits-Term S: P = D *S

Der Löslichkeitsterm S beschreibt vorwiegend die Affinität der Barriereklebemasse zum Permeaten. Im Fall von Wasserdampf wird beispielsweise ein geringer Wert für S von hydrophoben Materialen erreicht. Der Diffusionsterm D ist ein Maß für die Beweglichkeit des Permeaten im Barrierematerial und ist direkt abhängig von Eigenschaften wie der Molekülbeweglichkeit oder dem freien Volumen. Oft werden bei stark vernetzten oder hochkristallinen Materialen für D relativ niedrige Werte erreicht. Hochkristalline Materialien sind jedoch in der Regel weniger transparent, und eine stärkere Vernetzung führt zu einer geringeren Flexibilität. Die Permeabilität P steigt üblicherweise mit einer Erhöhung der molekularen Beweglichkeit an, etwa auch wenn die Temperatur erhöht oder der Glasübergangspunkt überschritten wird.

Ansätze, um die Barrierewirkung einer Klebemasse zu erhöhen, müssen die beiden Parameter D und S insbesondere berücksichtigen im Hinblick auf den Einfluss auf die Durchlässigkeit von Wasserdampf und Sauerstoff. Zusätzlich zu diesen chemischen Eigenschaften müssen auch Auswirkungen physikalischer Einflüsse auf die Permeabilität bedacht werden, insbesondere die mittlere Permeationsweglänge und Grenzflächeneigenschaften (Auffließverhalten der Klebemasse, Haftung). Die ideale Barriereklebemasse weist geringe D-Werte und S-Werte bei sehr guter Haftung auf dem Substrat auf.

Ein geringer Löslichkeits-Term S allein ist meist unzureichend, um gute Barriereeigenschaften zu erreichen. Ein klassisches Beispiel dafür sind insbesondere Siloxan-Elastomere. Die Materialien sind äußerst hydrophob (kleiner Löslichkeits-Term), weisen aber durch ihre frei drehbare Si-O-Bindung (großer Diffusions-Term) eine vergleichsweise geringe Barrierewirkung gegen Wasserdampf und Sauerstoff auf. Für eine gute Barrierewirkung ist also eine gute Balance zwischen Löslichkeits-Term S und Diffusions-Term D notwendig.

Hierfür wurden bisher vor allem Flüssigklebstoffe und Adhäsive auf Basis von Epoxiden verwendet (WO 98/21287 A1; US 4,051,195 A; US 4,552,604 A). Diese haben durch eine starke Vernetzung einen geringen Diffusionsterm D. Ihr Haupteinsatzgebiet sind Randverklebungen starrer Anordnungen, aber auch mäßig flexible Anordnungen. Eine Aushärtung erfolgt thermisch oder mittels UV-Strahlung. Eine vollflächige Verklebung ist aufgrund des durch die Aushärtung auftretenden Schrumpfes kaum möglich, da es beim Aushärten zu Spannungen zwischen Kleber und Substrat kommt, die wiederum zur Delaminierung führen können.

Der Einsatz dieser flüssigen Klebstoffe birgt eine Reihe von Nachteilen. So können niedermolekulare Bestandteile (VOC - volatile organic compound) die empfindlichen elektronischen Strukturen der Anordnung schädigen und den Umgang in der Produktion erschweren. Der Klebstoff muss aufwändig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess und auch durch den anschließend erforderlichen Laminationsschritt kann durch die geringe Viskosität das Erreichen einer definierten Schichtdicke und Verklebungsbreite in engen Grenzen erschwert sein.

Des Weiteren weisen solche hochvernetzten Klebstoffe nach dem Aushärten nur noch eine geringe Flexibilität auf. Der Einsatz von thermisch-vernetzenden Systemen wird im niedrigen Temperaturbereich oder bei 2-Komponenten-Systemen durch die Topfzeit begrenzt, also die Verarbeitungszeit bis eine Vergelung stattgefunden hat. Im hohen Temperaturbereich und insbesondere bei langen Reaktionszeiten begrenzen wiederum die empfindlichen (opto-)elektronischen Strukturen die Verwendbarkeit derartiger Systeme - die maximal anwendbaren Temperaturen bei (opto-)elektronischen Strukturen liegen manchmal nur bei 60°C, da bereits ab dieser Temperatur eine Vorschädigung eintreten kann. Insbesondere flexible Anordnungen, die organische Elektronik enthalten und mit transparenten Polymerfolien oder Verbunden aus Polymerfolien und anorganischen Schichten gekapselt sind, setzen hier enge Grenzen. Dies gilt auch für Laminierschritte unter großem Druck. Um eine verbesserte Haltbarkeit zu erreichen, ist hier ein Verzicht auf einen temperaturbelastenden Schritt und eine Laminierung unter geringerem Druck von Vorteil.

Alternativ zu den thermisch härtbaren Flüssigklebstoffen werden mittlerweile vielfach auch strahlenhärtende Klebstoffe eingesetzt (US 2004/0225025 A1). Die Verwendung von strahlenhärtenden Klebstoffen vermeidet eine lange andauernde Wärmebelastung der elektronischen Anordnung. Jedoch kommt es durch die Bestrahlung zu einer kurzfristigen punktuellen Erhitzung der Anordnung, da neben einer UV-Strahlung in der Regel auch ein sehr hoher Anteil an IR-Strahlung emittiert wird. Weitere oben genannte Nachteile von Flüssigklebstoffen wie VOC, Schrumpf, Delamination und geringe Flexibilität bleiben ebenfalls erhalten. Probleme können durch zusätzliche flüchtige Bestandteile oder Spaltprodukte aus den Photoinitiatoren oder Sensitizern entstehen. Zudem muss die Anordnung durchlässig für UV-Licht sein.

Da Bestandteile insbesondere organischer Elektronik und viele der eingesetzten Polymere häufig empfindlich gegen UV-Belastung sind, ist ein länger andauernder Außeneinsatz nicht ohne weitere zusätzliche Schutzmaßnahmen, etwa weitere Deckfolien möglich. Diese können bei UV-härtenden Klebesystemen erst nach der UV-Härtung aufgebracht werden, was die Komplexität der Fertigung und die Dicke der Anordnung zusätzlich erhöht.

Die US 2006/0100299 A1 offenbart ein UV-härtbares Haftklebeband zur Kapselung einer elektronischen Anordnung. Das Haftklebeband umfasst eine Klebemasse auf Basis einer Kombination eines Polymers mit einem Erweichungspunkt von größer 60°C, eines polymerisierbaren Epoxidharzes mit einem Erweichungspunkt von unter 30°C und eines Photoinitiator. Bei den Polymeren kann es sich um Polyurethan, Polyisobutylen, Polyacrylnitril, Polyvinylidenchlorid, Poly(meth)acrylat oder Polyester, insbesondere aber um ein Acrylat handeln. Des Weiteren sind Klebharze, Weichmacher oder Füllstoffe enthalten.

Acrylatmassen haben eine sehr gute Beständigkeit gegenüber UV-Strahlung und verschiedenen Chemikalien, besitzen aber sehr unterschiedliche Klebkräfte auf verschiedenen Untergründen. Während die Klebkraft auf polaren Untergründen wie Glas oder Metall sehr hoch ist, ist die Klebkraft auf unpolaren Untergründen wie beispielsweise Polyethylen oder Polypropylen eher gering. Hier besteht die Gefahr der Diffusion an der Grenzfläche in besonderem Maße. Zudem sind diese Massen sehr polar, was eine Diffusion insbesondere von Wasserdampf, trotz nachträglicher Vernetzung, begünstigt. Durch den Einsatz polymerisierbarer Epoxidharze wird diese Tendenz weiter verstärkt.

Haftklebebänder benötigen in der Regel durch die relativ hochmolekularen Polymere im Gegensatz zu Flüssigklebstoffen für eine gute Benetzung und Haftung auf der Oberfläche eine gewisse Zeit, ausreichenden Druck und eine gute Balance zwischen viskosem Anteil und elastischen Anteil.

Die WO 2007/087281 A1 offenbart ein transparentes flexibles Haftklebeband auf Basis von Polyisobutylen (PIB) für elektronische Anwendungen, insbesondere OLED. Dabei wird Polyisobutylen mit einem Molekulargewicht von mehr als 500.000 g/mol und ein hydriertes cyclisches Harz verwendet. Optional ist der Einsatz eines photopolymerisierbaren Harzes und eines Photoinitiators möglich.

Klebemassen auf der Basis von Polyisobutylen weisen aufgrund ihrer geringen Polarität eine gute Barriere gegen Wasserdampf auf, haben aber selbst bei hohen Molekulargewichten eine relativ geringe Kohäsivität, weshalb sie bei erhöhten Temperaturen häufig eine geringe Scherfestigkeit aufweisen. Der Anteil an niedermolekularen Bestandteilen kann nicht beliebig reduziert werden, da sonst die Haftung deutlich verringert wird und die Grenzflächenpermeation zunimmt. Bei Einsatz eines hohen Anteils an funktionellen Harzen, der aufgrund der sehr geringen Kohäsion der Masse notwendig ist, wird die Polarität der Masse wieder erhöht und damit der Löslichkeits-Term vergrößert.

Beschrieben sind weiterhin Barriereklebemassen auf der Basis von Styrolblockcopolymeren und möglichst hydrierten Harzen (siehe DE 10 2008 047 964 A1).

Hier werden auch Permeationswerte (WVTR) von weit verbreiteten Klebstoffsystemen angegeben (gemessen bei 37.5 °C und 90% relativer Feuchte). Typische Haftklebemassen auf Acrylatbasis liegen im Bereich zwischen 100 g/m² d und 1000 g/m² d. Silikonhaftklebemassen haben aufgrund der hohen Beweglichkeit der Ketten noch höhere Permeationswerte für Wasser von über 1000 g/m² d. Werden Styrolblockcopolymere als Elastomerkomponente verwendet, so werden für nicht oder nicht-vollständig hydrierteSysteme WVTR-Werte im Bereich von 50 bis 100 g/m² d und für hydrierte Systeme (zum Beispiel SEBS) Werte unter 50 g/m² d erreicht. Besonders niedrige WVTR-Werte von unter 15 g/m² d werden sowohl mit reinen Poly(isobutylen)elastomeren oder Blockcopolymeren aus Styrol und Isobutylen erreicht.
Durch die Bildung von zumindest zwei Domänen innerhalb des Blockcopolymers erhält man zusätzlich eine sehr gute Kohäsion bei Raumtemperatur und gleichzeitig verbesserte Barriereeigenschaften.

Eine Möglichkeit, die Barrierewirkung noch zu verbessern, ist der Einsatz von Stoffen, die mit Wasser oder Sauerstoff reagieren. In die (opto-)elektronische Anordnung eindringender Sauerstoff oder Wasserdampf wird dann an diese Stoffe chemisch oder physikalisch, bevorzugt chemisch gebunden. Diese Stoffe werden in der Literatur als "Getter", "scavenger", "desiccants" oder "absorber" bezeichnet. Im Folgenden wird nur der Ausdruck Getter verwendet. Beschrieben als solche Getter sind in Klebmassen hauptsächlich anorganische Füllstoffe wie beispielsweise Calciumchlorid oder verschiedene Oxide. Da diese in der Klebmasse nicht löslich sind, haben sie den Nachteil, dass die Klebmasse ihre Transparenz und bei entsprechenden Füllgraden an Haftung verliert. Daher sind organische Getter oder Hybride, die in der Klebmasse löslich sind, besser geeignet, sie dürfen allerdings nicht aus der Klebmasse zur organischen Elektronik herauswandern. Diese Zusatzstoffe ändern weniger die Diffusionswerte, sondern im Wesentlichen die Durchbruchzeit, das heißt, die Zeit die Feuchtigkeit benötigt, um die Strecke durch die Klebmasse zurückzulegen und den empfindlichen elektronischen Aufbau zu erreichen. Sind die Stoffe mit Wasser beziehungsweise Sauerstoff gesättigt oder in einer chemischen Reaktion mit Wasser beziehungsweise Sauerstoff aufgebraucht, haben sie auch keine Wirkung mehr, die Diffusion ist dann nur die der Klebmasse ohne Getter. Trotzdem können diese Getter die Lebensdauer der (opto)-elektronischen Bauteile erhöhen.

Gettermaterialien sind zusammenfassend beispielsweise Salze wie Cobaltchlorid, Calciumchlorid, Calciumbromid, Lithiumchlorid, Lithiumbromid, Magnesiumchlorid, Bariumperchlorat, Magnesiumperchlorat, Zinkchlorid, Zinkbromid, Kieselsäuren (zum Beispiel Silica Gel), Aluminiumsulfat, Calciumsulfat, Kupfersulfat, Bariumsulfat, Magnesiumsulfat, Lithiumsulfat, Natriumsulfat, Cobaltsulfat, Titansulfat, Natriumdithionit, Natriumcarbonat, Kaliumdisulfit, Kaliumcarbonat, Magnesiumcarbonat, Titandioxid, Kieselgur, Zeolithe, Schichtsilikate wie Montmorillonit und Bentonit, Metalloxide wie Bariumoxid, Calciumoxid, Eisenoxid, Magnesiumoxid, Natriumoxid, Kaliumoxid,Strontiumoxid, Aluminiumoxid (aktiviertes Alumina); weiter Kohlenstoffnanoröhrchen, Aktivkohle, Phosphorpentoxid und Silane; leicht oxidierbare Metalle wie beispielsweise Eisen, Calcium, Natrium und Magnesium; Metallhydride wie beispielsweise Calciumhydrid, Bariumhydrid, Strontiumhydrid, Natriumhydrid und Lithiumaluminiumhydrid; Hydroxide wie Kaliumhydroxid und Natriumhydroxid, Metallkomplexe wie zum Beispiel Aluminiumacetylacetonat; des Weiteren organische Absorber, beispielsweise Polyolefin-Copolymere, Polyamid-Copolymere, PET-Copolyester, Anhydride von einfachen und mehrfachen Carbonsäuren wie Essigsäureanhydrid, Propionsäureanhydrid, Buttersäureanhydrid oder Methyltetrahydrophtalsäureanhydrid, Isocyanate oder weitere auf Hybridpolymeren basierte Absorber, die meist in Kombination mit Katalysatoren wie beispielsweise Cobalt verwendet werden; weitere organische Absorber wie etwa schwach vernetzte Polyacrylsäure, Polyvinylalkohol, Ascorbate, Glucose, Gallussäure oder ungesättigte Fette und Öle.

Die Gettermaterialien werden ihrer Funktion entsprechend bevorzugt als im Wesentlichen von Permeaten freie Materialien eingesetzt, zum Beispiel wasserfrei. Dies unterscheidet Gettermaterialien von ähnlichen Materialien, die als Füllstoff eingesetzt werden. So wird Silica zum Beispiel in der Form von pyrogener Kieselsäure häufig als Füllstoff eingesetzt. Wird dieser Füllstoff jedoch wie üblich unter Umgebungsbedingungen gelagert, nimmt er bereits Wasser aus der Umgebung auf und ist nicht mehr in technisch nutzbarem Umfang als Gettermaterial funktionsfähig. Erst getrocknetes oder trocken gehaltenes Silica kann als Gettermaterial genutzt werden. Es ist jedoch auch möglich, bereits teilweise mit Permeaten komplexierte Materialien zu verwenden, beispielsweise CaSO₄*1/2H₂O (Calciumsulfat-Halbhydrat) oder teilhydrierte Kieselsäuren, die per Definition als Verbindungen der allgemeinen Formel (SiO₂)m*nH₂O vorliegen.

Unter Kieselsäuren werden, wie vorstehend beschrieben, Verbindungen der allgemeinen Formel (SiO₂)m*nH₂O verstanden. Es handelt sich dabei um durch nasschemische, thermische oder pyrogene Verfahren hergestelltes Siliciumdioxid. Insbesondere sind unter den Kieselsäuren Kieselgele beziehungsweise Silicagele, beispielsweise mit KobaltVerbindungen als Feuchteindikator imprägnierte Kieselgele (Blaugel), und pyrogene Kieselsäuren geeignete Gettermaterialien.

Beispiele für die Verwendung von Gettern in Flüssigklebersystemen zur Verkapselung (opto-)elektronischer Aufbauten sind zum Beispiel in US 6,833,668 B1, JP 2000 311 782 A und EP 1 037 192 A2 gegeben.

Aus dem Stand der Technik ist zudem eine Haftklebemasse bekannt (WO 03/065470 A1), die in einem elektronischen Aufbau als Transferklebemasse verwendet wird. Die Klebemasse enthält einen anorganischen funktionellen Füllstoff, der mit Sauerstoff oder Wasserdampf innerhalb des Aufbaus reagiert. Damit ist eine einfache Applikation eines Getters innerhalb des Aufbaus möglich. Für die Versiegelung des Aufbaus nach außen wird ein weiteres Adhäsiv mit geringer Durchlässigkeit verwendet. Eine ähnliche Haftklebemasse findet ihre Anwendung in JP 2004 296 381 A. Auch hier werden ausschließlich anorganische Getter verwendet.

Die DE 10 2010 043 866 A1 beschreibt eine Klebemasse zur Verkapselung, die silanmodifizierte Polymere enthält. Die Klebemasse weist gegenüber dem in der Schrift genannten Stand der Technik in gewissem Rahmen verbesserte Durchbruchszeiten auf. Trotzdem ist eine weitere Verbesserung der Durchbruchszeiten wünschenswert. Jedoch sind die hier beschriebenen silanmodifizierten Polymere monofunktionell, das heißt, es sind lediglich die silanisierten Säureanhydridgruppen und eventuell nicht abreagierte Anhydridgruppen vorhanden. Es sind keine polymerisierbaren Gruppen enthalten.

Aus dem Stand der Technik ist bekannt, dass Alkoxysilane als Wasserfänger eingesetzt werden können. In der EP 1 394 199 A1 dienen Alkoxysilane als Wasserfänger, Trockenmittel oder Vorvernetzungsverhinderer, mit anderen Worten als Stabilisatoren für insbesondere feuchtvernetzende Dichtmassen. Dabei kommen mit gleichem Erfolg sowohl monomere wie auch oligomere Alkoxysilane zum Einsatz.
Die DE 10 2012 202377 A1 betrifft eine Klebemasse insbesondere zur Kapselung einer elektronischen Anordnung gegen Permeate, umfassend
(a) zumindest ein Copolymer enthaltend zumindest Isobutylen oder Butylen als Comonomersorte und zumindest eine Comonomersorte, die - als hypothetisches Homopolymer betrachtet - eine Erweichungstemperatur von größer 40 °C aufweist,
(b) zumindest eine Sorte eines zumindest teilhydrierten Klebharzes,
(c) zumindest eine Sorte eines Reaktivharzes basierend auf cyclischen Ethern mit einer Erweichungstemperatur von kleiner 40 °C, bevorzugt kleiner 20 °C,
(d) zumindest eine Sorte eines Photoinitiators für die Initiierung einer kationischen Härtung.

Die WO 2013/165010 A1 betrifft ein filmartiges, thermohärtendes Dichtungsmaterial auf Silikonbasis zum Abdichten eines Halbleiterelements mittels eines Pressverfahrens, wobei das Dichtungsmaterial ein anfängliches Drehmoment von weniger als 15 dN·m aufweist, wie mittels Bewegungsdüsenrheometer (MDR) bei einer Formtemperatur von Raumtemperatur bis 200 °C gemessen.

Der Erfindung lag die Aufgabe zugrunde, eine Klebemasse zur Verfügung zu stellen, die gegenüber dem Stand der Technik deutlich verbesserte Durchbruchszeiten aufweist, wobei sich gleichzeitig die Eigenschaften der Klebemasse nicht wesentlich verschlechtern dürfen. Die Klebemasse muss nach wie vor leicht handzuhaben und einfach applizierbar sein.

Überraschenderweise wurde gefunden, dass sich die Durchbruchszeiten einer eingangs genannten wasserdampfsperrenden Klebemasse relevant verbessern, wenn die Klebemasse mindestens ein multifunktionelles oligomeres Alkoxysiloxan enthält, wobei das oligomere Alkoxysiloxan mehr als eine polymerisierbare Gruppe und mehr als eine Alkoxygruppe enthält. Dabei weist das Alkoxysiloxan vorzugsweise pro Si-Atom eine Alkoxygruppe und eine polymerisierbare Gruppe auf. Dabei kann die Alkoxygruppe gleich oder verschieden zu benachbarten Si-Alkoxygruppen sein. Ebenso kann die polymerisierbare Gruppe benachbarter Wiederholungseinheiten gleich oder verschieden sein.

Grundsätzlich lässt sich die Durchbruchzeit von wasserdampfsperrenden oder Barriereklebemassen mit Alkoxysilanverbindungen im Vergleich zu Barriereklebemassen ohne Zusatz solcher Moleküle bereits erhöhen. Die Performance des multifunktionellen Siloxangetters liegt jedoch überraschend noch darüber, obwohl die relative Menge an wasserfangenden Gruppen niedriger ist.

Die polymerisierbaren Gruppen werden im Aushärtungsschritt in das Netzwerk des Reaktivharzes mit eingebunden, sodass es im Vergleich zu Klebmassen ohne Getterzusatz nicht zu einer Erniedrigung der Netzpunktdichte kommt. Klebmassen mit monomeren Alkoxysiloxanen zeigen im Vergleich zu Klebmassen ohne Getterzusatz keine signifikante Verbesserung der Durchbruchzeit von Wasser. Hier kommt es zu einer Reduktion der Netzdichte im Vergleich zu Massen ohne Getterzusatz. Dies bewirkt, dass die Diffusion aufgrund des weniger engen Netzwerks erleichtert wird und somit trotz der Getterfunktion die Performance nicht so deutlich steigt wie mit dem zusätzlich als Vernetzer fungierenden multifunktionellen oligomeren Siloxan gemäß der vorliegenden Erfindung. Oligomere Siloxane, die nicht multifunktionell sind, das heißt zwar Alkoxygruppen, nicht jedoch eine weitere funktionelle, polymerisierbare Gruppe aufweisen, härten im Aushärtungsschritt nicht. Somit wirken diese als eine Art Weichmacher und ermöglichen auch eine leichtere Permeation von Wassermolekülen, sodass die Performance der Barriereklebemasse trotz der Alkoxysilangruppen vergleichbar mit der Klebmasse ohne Getteradditivierung ist.

Die erfindungsgemäße Klebemasse ist teilvernetzbar, da sie neben der mindestens einen Reaktivharzkomponente auch noch mindestens ein Polymer, insbesondere einem Elastomer und optional ein Klebharz enthält. Geeigneterweise liegt der Gelgehalt der Klebemasse, das heißt derjenige Anteil der Klebemasse, der sich bei Lösen der Klebemasse in einem geeigneten Lösungsmittel nicht lösen lässt, bei weniger als 90 Gew.-%, insbesondere bei weniger als 80 Gew.-%, vorzugsweise bei weniger als 70 Gew.-%, besonders bevorzugt bei weniger als 50 Gew.-% und ganz besonders bevorzugt bei weniger als 30 Gew.-%.

Besonders bevorzugt sind solche Klebemassen, deren Klebstoffbasis eine Wasserdampfpermeationsrate nach der Aktivierung der Reaktivharzkomponente von weniger als 100 g/m²d, bevorzugt von weniger als 50 g/m²d, insbesondere weniger als 15 g/m²d aufweist.

Vorzugsweise ist das mindestens eine Alkoxysiloxan eine Verbindung der allgemeinen Formel 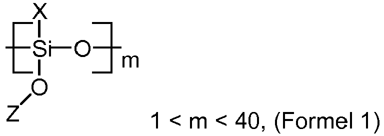 wobei X einen Rest mit polymerisierbarer Gruppe, ausgewählt aus cyclischem Ether, Vinyl, Acrylat, Methacrylat, Hydroxyl, Amino, und Isocyanat ist, wobei Z eine Alkyl- oder Arylgruppe ist, wobei Rest X gleich oder verschieden sein kann, wobei Rest Z gleich oder verschieden sein kann. So kann das Alkoxysiloxan zum Beispiel ein Copolymer aus zwei verschiedenen Alkoxysiloxanen sein, von denen eines ein Epoxid, das andere eine Vinylgruppe als polymerisierbare Gruppe aufweist.

Der Rest Z kann eine beliebige Alkyl- oder Arylgruppe sein, wobei eine Methyl- oder Ethylgruppe besonders bevorzugt ist. Der Rest Z kann auch unterschiedlich sein. So kann das Alkoxysiloxan als Rest Z sowohl Methyl- wie auch Ethylgruppen enthalten.

In einer besonders geeigneten Ausführung enthält der Rest X eine polymerisierbare funktionelle Gruppe ausgewählt aus cyclischen Ethern, insbesondere Oxiran und/oder Oxetan, Acrylat, Methacrylat, Vinyl, wobei Vinyl und cyclische Ether, hierbei insbesondere 3,4-Epoxycyclohexyl, besonders bevorzugt sind.

Bevorzugt ist der multifunktionelle Getter ein oligomeres Alkoxysiloxan von Vinyltrimethoxysilan und/oder Vinyltriethoxysilan.

In einer anderen bevorzugten Ausführung enthält die Gruppe X des multifunktionellen Getters eine cyclische Ethergruppe, wobei als Getter oligomere Alkoxysiloxane von 2-(3,4-Epoxycyclohexyl)ethylmethyldimethoxysilan, 2-(3,4-Epoxycyclohexyl)ethylmethyldiethoxysilan, gamma-(Glycidoxypropyl)trimethoxysilan, gamma-(Glycidoxypropyl)triethoxy-silan sowie insbesondere 2-(3,4-Epoxycyclohexyl)ethyltrimethoxysilan und/oder 2-(3,4-Epoxycyclohexyl)ethyltriethoxysilan besonders bevorzugt sind

Der Anteil an oligomerem Alkoxysiloxan an der Klebmassenzusammensetzung beträgt vorzugsweise 0,5 bis 90 Gew.-%, insbesondere 2 bis 90 Gew.-% und besonders bevorzugt 5 bis 80 Gew.-%.

Klebemassen mit einem hohen Anteil an oligomerem Alkoxysiloxan weisen eine hohe Wasseraufnahmekapazität auf, so dass ein hoher Anteil, vorzugsweise 15 bis 80 Gew.-%, insbesondere 15 bis 70 Gew.-%, besonders bevorzugt 20 bis 65 Gew.-%, besonders vorteilhaft ist. Dabei bezieht sich dieser Anteil hier und auch im Folgenden auf die Klebmassenzusammensetzung ohne ein optional enthaltenes Lösemittel, sofern dies nicht anders angegeben ist.

Auf der anderen Seite ist das oligomere Alkoxysiloxan häufig niedrigviskos. Dies wirkt sich auf die Eigenschaften, insbesondere die Handhabbarkeit der Klebemasse aus. Daher sind in einer weiteren bevorzugten Ausführung der Klebemasse 0,5 bis 5 Gew.-%, besonders bevorzugt 0,5 bis 2 Gew.-%, (bezogen auf die Klebmassenzusammensetzung) des oligomeren Alkoxysiloxans enthalten.

Schließlich sind solche Klebemassen bevorzugt, die hinsichtlich ihrer Eigenschaften in Bezug auf Handhabbarkeit und Wasseraufnahmekapazität besonders ausgewogen sind und die 2 bis 25 Gew.-%, insbesondere 2 bis 15 Gew.-% und besonders bevorzugt 5 bis 15 Gew.-% (bezogen auf die Klebmassenzusammensetzung) des oligomeren Alkoxysiloxans enthalten.

Das Polymer kann ein Polymer sein, aber auch eine Mischung von zwei oder mehr verschiedenen Polymeren sein. Dabei kann das mindestens eine Polymer insbesondere ein Elastomer oder ein Thermoplast sein.

Als Elastomere können prinzipiell alle im Bereich der Haftklebemassen üblichen Elastomere verwendet werden, wie sie zum Beispiel in dem "Handbook of Pressure Sensitive Adhesive Technology" von Donatas Satas (Satas & Associates, Warwick 1999), beschrieben sind.

Bevorzugt im Sinne der Anmeldung sind die verwendeten Elastomere chemisch aus zumindest einem olefinischen Monomer oder aus Polyurethan aufgebaut und sind zum Beispiel Elastomere auf der Basis von Polyurethanen, Naturkautschuken, Synthesekautschuken wie Butyl-, (Iso)Butyl-, Nitril- oder Butadienkautschuke, Styrolblockcopolymeren mit einem Elastomerblock aus ungesättigten oder teilweise oder vollständig hydrierten Polydienblöcken (Polybutadien, Polyisopren, Poly(iso)butylen, Copolymeren aus diesen sowie weitere, dem Fachmann geläufige Elastomerblöcke), Polyolefinen, Fluorpolymeren und/oder Silikonen.

Kommt Kautschuk oder Synthesekautschuk oder daraus erzeugte Verschnitte als Basismaterial für die Haftklebemasse zum Einsatz, dann kann der Naturkautschuk grundsätzlich aus allen erhältlichen Qualitäten wie zum Beispiel Crepe-, RSS-, ADS-, TSR- oder CV-Typen, je nach benötigtem Reinheits- und Viskositätsniveau, und der Synthesekautschuk oder die Synthesekautschuke aus der Gruppe der statistisch copolymerisierten Styrol-Butadien-Kautschuke (SBR), der Butadien-Kautschuke (BR), der synthetischen Polyisoprene (IR), der Butyl-Kautschuke (IIR), der halogenierten Butyl-Kautschuke (XIIR), der Acrylat-Kautschuke (ACM), der Ethylenvinylacetat-Copolymere (EVA) oder der Polyurethane und/oder deren Verschnitten gewählt werden.

Als das mindestens eine Polymer kann auch jegliche dem Fachmann bekannte Art von Thermoplasten zum Einsatz kommen, wie sie zum Beispiel in den Lehrbüchern "Chemie und Physik der synthetischen Polymere" von J.M.G. Cowie (Vieweg, Braunschweig) und "Makromolekulare Chemie" von B. Tieke (VCH Weinheim, 1997) genannt sind. Dies sind zum Beispiel Poly(ethylen), Poly (propylen), Poly (vinylchlorid), Poly (styrol), Poly (oxymethylene), Poly (ethylenoxid), Poly (ethylenterephthalat), Poly (carbonate), Poly (phenylenoxide), Poly (urethane), Poly(harnstoffe), Phenoxy-Harze, Acrylnitril-Butadien-Styrol (ABS), Poly(amide) (PA), Poly (lactat) (PLA), Poly (etheretherketon) (PEEK), Poly (sulfon) (PSU), Poly (ethersulfon) (PES). Poly (acrylate), Poly (methacrylate) und Poly (methylmethacrylate) (PMMA) sind zwar als Polymer ebenfalls möglich, jedoch nicht bevorzugt im Sinne der vorliegenden Erfindung.

Als Reaktivharze, auch als vernetzbare Komponenten bezeichnet, können im Prinzip alle, dem Fachmann im Bereich der Haftklebemassen oder Reaktivklebstoffe bekannten, in einer Aufbaureaktion vernetzenden Makromoleküle bildenden reaktiven Konstituenten verwendet werden, wie sie zum Beispiel in Gerd Habenicht: Kleben -Grundlagen, Technologien, Anwendungen, 6. Auflage, Springer, 2009, beschrieben sind. Dies sind beispielhaft Konstituenten, die Epoxide, Polyester, Polyether, Polyurethane, Phenolharz, Kresol oder Novolak basierte Polymere, Polysulfide oder Acrylpolymere (Acryl, Methacryl) bilden.

Der Aufbau und die chemische Beschaffenheit der vernetzbaren Komponenten sind nicht kritisch, solange sie mit der Elastomerphase zumindest teilweise mischbar sind und die Aufbaureaktion unter Bedingungen, insbesondere hinsichtlich der angewendeten Temperaturen, Art der verwendeten Katalysatoren und dergleichen, durchgeführt werden kann, die zu keiner wesentlichen Beeinträchtigung und/oder Zersetzung der Elastomerphase führen.

Das Reaktivharz besteht bevorzugt aus einem cyclischen Ether und eignet sich für die strahlenchemische und gegebenenfalls thermische Vernetzung mit einer Erweichungstemperatur von kleiner 40 °C, bevorzugt von kleiner 20 °C.

Bei den Reaktivharzen auf Basis cyclischer Ether handelt es sich insbesondere um Epoxide, also Verbindungen, die zumindest eine Oxiran-Gruppe tragen, oder Oxetane. Sie können aromatischer oder insbesondere aliphatischer oder cycloaliphatischer Natur sein.

Einsetzbare Reaktivharze können monofunktionell, difunktionell, trifunktionell, tetrafunktionell oder höher funktionell bis zu polyfunktionell gestaltet sein, wobei sich die Funktionalität auf die cyclische Ethergruppe bezieht.

Beispiele, ohne sich einschränken zu wollen, sind 3,4-Epoxycyclohexylmethyl-3',4'-epoxycyclohexancarboxylat (EEC) und Derivate, Dicyclopendadiendioxid und Derivate, 3-Ethyl-3-oxetanmethanol und Derivate, Tetrahydrophthalsäurediglycidylester und Derivate, Hexahydrophthalsäurediglycidylester und Derivate, 1,2-Ethandiglycidylether und Derivate, 1,3-Propandiglycidylether und Derivate, 1,4-Butandioldiglycidylether und Derivate, höhere 1,n-Alkandiglycidylether und Derivate, Bis-[(3,4-epoxycyclohexyl)methyl]-adipat und Derivate, Vinylcyclohexyldioxid und Derivate, 1,4-Cyclohexandimethanol-bis-(3,4-epoxycyclohexancarboxylat) und Derivate, 4,5-Epoxytetrahydrophthalsäurediglycidylester und Derivate, Bis-[1-ethyl(3-oxetanyl)methyl)ether und Derivate, Pentaerythritoltetraglycidylether und Derivate, Bisphenol-A-Digylcidylether (DGEBA), hydriertes Bisphenol-A-Diglycidylether, Bisphenol-F-Diglycidylether, hydriertes Bisphenol-F-Diglycidylether, Epoxyphenol-Novolaks, hydrierte Epoxyphenol-Novolaks, Epoxycresol-Novolaks, hydrierte Epoxycresol-Novolaks, 2-(7-Oxabicyclo;Spiro[1,3-dioxane-5,3'-[7]oxabicyclo[4.1.0]-heptane], 1,4-Bis((2,3-epoxypropoxy)methyl)cyclohexane.

Zur kationischen Härtung eignen sich besonders Reaktivharze auf Cyclohexylepoxid-Basis wie beispielsweise 3,4-Epoxycyclohexylmethyl-3',4'-epoxycyclohexancarboxylat (EEC) und Derivate sowie Bis-[(3,4-epoxycyclohexyl)methyl]-adipat und Derivate.

Reaktivharze können in ihrer monomeren oder auch dimeren, trimeren, usw. bis hin zu ihrer oligomeren Form eingesetzt werden.

Gemische von Reaktivharzen untereinander aber auch mit anderen coreaktiven Verbindungen wie Alkoholen (monofunktionell oder mehrfach funktionell) oder Vinylethern (monofunktionell oder mehrfach funktionell) sind ebenfalls möglich.

Unter den Initiatoren für eine kationische UV-Härtung sind insbesondere Sulfonium, lodonium und Metallocen basierende Systeme einsetzbar. Als Beispiele für Sulfonium basierende Kationen sei auf die Ausführungen in US 6,908,722 B1 (insbesondere Spalten 10 bis 21) verwiesen.

Als Beispiele für Anionen, die als Gegenionen für die oben genannten Kationen dienen, seien Tetrafluoroborat, Tetraphenylborat, Hexafluorophosphat, Perchlorat, Tetrachloroferrat, Hexafluoroarsenat, Hexafluoroantimonat, Pentafluorohydroxyantimonat, Hexachloroantimonat, Tetrakispentafluorophenylborat, Tetrakis-(pentafluoromethylphenyl)-borat, Bi-(trifluoromethylsulfonyl)-amide und Tris-(trifluoromethylsulfonyl)-methide genannt. Ferner sind insbesondere für Iodonium-basierende Initiatoren auch Chlorid, Bromid oder lodid als Anionen denkbar, wobei aber Initiatoren, die im Wesentlichen frei von Chlor und Brom sind, bevorzugt sind.

Konkreter zählen zu den einsetzbaren Systemen
- Sulfonium-Salze (siehe zum Beispiel US 4,231,951 A, US 4,256,828 A, US 4,058,401 A, US 4,138,255 A und US 2010/063221 A1) wie Triphenylsulfoniumhexafluoroarsenat, Triphenylsulfoniumhexafluoroborat, Triphenylsulfoniumtetrafluoroborat, Triphenylsulfoniumtetrakis-(pentafluorobenzyl)-borat, Methyldiphenylsulfoniumtetrafluoroborat, Methyldiphenylsulfoniumtetrakis-(pentafluorobenzyl)-borat, Dimethylphenylsulfoniumhexafluorophosphat, Triphenylsulfoniumhexafluorophosphat, Triphenylsulfoniumhexafluoroantimonat, Diphenylnaphthylsulfoniumhexafluoroarsenat, Tritolylsulfoniumhexafluorophosphat, Anisyldiphenylsulfoniumhexafluoroantimonat, 4-Butoxyphenyldiphenylsulfoniumtetrafluoroborat, 4-Chlorophenyldiphenylsulfoniumhexafluoroantimonat, Tris-(4-phenoxyphenyl)-sulfoniumhexafluorophosphat, Di-(4-ethoxyphenyl)-methylsulfoniumhexafluoroarsenat, 4-Acetylphenyldiphenylsulfoniumtetrafluoroborat, 4-Acetylphenyldiphenylsulfoniumtetrakis-(pentafluorobenzyl)-borat, Tris-(4-thiomethoxyphenyl)-sulfoniumhexafluorophosphat, Di-(methoxysulfonylphenyl)-methylsulfoniumhexafluoroantimonat, Di-(methoxynaphthyl)-methylsulfoniumtetrafluoroborat, Di-(methoxynaphthyl)-methylsulfoniumetrakis-(pentafluorobenzyl)-borat, Di-(carbomethoxyphenyl)-methylsulfoniumhexa-fluorophosphat, (4-Octyloxyphenyl)-diphenylsulfoniumtetrakis-(3,5-bis-trifluoromethylphenyl)-borat, Tris-[4-(4-acetylphenyl)-thiophenyl]-sulfoniumtetrakis-(pentafluorophenyl)-borat, Tris-(dodecylphenyl)-sulfoniumtetrakis-(3,5-bis-trifluoromethylphenyl)-borat, 4-Acetamidphenyldiphenylsulfoniumtetrafluoroborat, 4-Acetamidphenyldiphenylsulfoniumtetrakis-(pentafluorobenzyl)-borat, Dimethylnaphthylsulfoniumhexafluorophosphat, Trifluoromethyldiphenylsulfoniumtetrafluoroborat, Trifluoromethyldiphenylsulfoniumtetrakis-(pentafluorobenzyl)-borat, Phenylmethylbenzylsulfoniumhexafluorophosphat, 5-Methylthianthreniumhexafluorophosphat, 10-Phenyl-9,9-dimethylthioxantheniumhexafluorophosphat, 10-Phenyl-9-oxothioxantheniumtetrafluoroborat, 10-Phenyl-9-oxothioxantheniumtetrakis-(pentafluorobenzyl)-borat, 5-Methyl-10-oxothianthreniumtetrafluoroborat, 5-Methyl-10-oxothianthreniumtetrakis-(pentafluorobenzyl)-borat und 5-Methyl-10,10-dioxothianthreniumhexafluorophosphat,
- Iodonium-Salze (siehe zum Beispiel US 3,729,313 A, US 3,741,769 A, US 4,250,053 A, US 4,394,403 A und US 2010/063221 A1) wie Diphenyliodoniumtetrafluoroborat, Di-(4-methylphenyl)-iodoniumtetrafluoroborat, Phenyl-4-methylphenyliodoniumtetrafluoroborat, Di-(4-chlorphenyl)-iodoniumhexafluorophosphat, Dinaphthyliodoniumtetrafluoroborat, Di-(4-trifluormethylphenyl)-iodoniumtetrafluoroborat, Diphenyliodoniumhexafluorophosphat, Di-(4-methylphenyl)-iodoniumhexafluorophosphat, Diphenyliodoniumhexafluoroarsenat, Di-(4-phenoxyphenyl)-iodoniumtetrafluoroborat, Phenyl-2-thienyliodoniumhexafluorophosphat, 3,5-Dimethylpyrazolyl-4-phenyliodoniumhexafluorophosphat, Diphenyliodoniumhexafluoroantimonat, 2,2'-Diphenyliodoniumtetrafluoroborat, Di-(2,4-dichlorphenyl)-iodoniumhexafluorophosphat, Di-(4-bromphenyl)-iodoniumhexafluorophosphat, Di-(4-methoxyphenyl)-iodoniumhexafluorophosphat, Di-(3-carboxyphenyl)-iodoniumhexafluorophosphat, Di-(3-methoxycarbonylphenyl)-iodoniumhexafluorophosphat, Di-(3-methoxysulfonylphenyl)-iodoniumhexafluorophosphat, Di-(4-acetamidophenyl)-iodoniumhexafluorophosphat, Di-(2-benzothienyl)-iodoniumhexafluorophosphat, Diaryliodoniumtristrifluormethylsulfonylmethid wie Diphenyliodoniumhexafluoroantimonat, Diaryliodoniumtetrakis-(pentafluorophenyl)-borat wie Diphenyliodoniumtetrakis-(pentafluorophenyl)-borat" (4-n-Desiloxyphenyl)-phenyliodoniumhexafluoroantimonat, [4-(2-Hydroxy-n-tetradesiloxy)-phenyl]-phenyliodoniumhexafluoroantimonat, [4-(2-Hydroxy-n-tetradesiloxy)-phenyl]-phenyliodoniumtrifluorosulfonat, [4-(2-Hydroxy-n-tetradesiloxy)-phenyl]-phenyliodoniumhexafluorophosphat, [4-(2-Hydroxy-n-tetradesiloxy)-phenyl]-phenyliodoniumtetrakis-(pentafluorophenyl)-borat, Bis-(4-tert-butylphenyl)-iodoniumhexafluoroantimonat, Bis-(4-tert-butylphenyl)-iodoniumhexafluorophosphat, Bis-(4-tert-butylphenyl)-iodoniumtrifluorosulfonat, Bis-(4-tert-butylphenyl)-iodoniumtetrafluoroborat, Bis-(dodecylphenyl)-iodoniumhexafluoroantimonat, Bis-(dodecylphenyl)-iodoniumtetrafluoroborat, Bis-(dodecylphenyl)-iodoniumhexafluorophosphat, Bis-(dodecylphenyl)-iodoniumtrifluoromethylsulfonat, Di-(dodecylphenyl)-iodoniumhexafluoroantimonat, Di-(dodecylphenyl)-iodoniumtriflat, Diphenyliodoniumbisulfat, 4,4'-Dichlorodiphenyliodoniumbisulfat, 4,4'-Dibromodiphenyliodoniumbisulfat, 3,3'-Dinitrodiphenyliodoniumbisulfat, 4,4'-Dimethyldiphenyliodoniumbisulfat, 4,4'-Bis-succinimidodiphenyliodoniumbisulfat, 3-Nitrodiphenyliodoniumbisulfat, 4,4'-Dimethoxydiphenyliodoniumbisulfat, Bis-(dodecylphenyl)-iodoniumtetrakis-(pentafluorophenyl)-borat, (4-Octyloxyphenyl)-phenyliodoniumtetrakis-(3,5-bis-trifluoromethylphenyl)-borat und (Tolylcumyl)-iodoniumtetrakis-(pentafluorophenyl)-borat,
   und
- Ferrocenium-Salze (siehe zum Beispiel EP 0 542 716 B1) wie η5-(2,4-cyclopentadien-1-yl)-[(1,2,3,4,5,6,9)-(1-methylethyl)-benzol]-eisen.

Beispiele für kommerzialisierte Photoinitiatoren sind Cyracure UVI-6990, Cyracure UVI-6992, Cyracure UVI-6974 und Cyracure UVI-6976 der Firma Union Carbide, Optomer SP-55, Optomer SP-150, Optomer SP-151, Optomer SP-170 und Optomer SP-172 der Firma Adeka, San-Aid SI-45L, San-Aid SI-60L, San-Aid SI-80L, San-Aid SI-100L, San-Aid SI-110L, San-Aid SI-150L und San-Aid SI-180L der Firma Sanshin Chemical, SarCat CD-1010, SarCat CD-1011 und SarCat CD-1012 der Firma Sartomer, Degacure K185 der Firma Degussa, Rhodorsil Photoinitiator 2074 der Firma Rhodia, CI-2481, CI-2624, CI-2639, CI-2064, CI-2734, CI-2855, CI-2823 und CI-2758 der Firma Nippon Soda, Omnicat 320, Omnicat 430, Omnicat 432, Omnicat 440, Omnicat 445, Omnicat 550, Omnicat 550 BL und Omnicat 650 der Firma IGM Resins, Daicat II der Firma Daicel, UVAC 1591 der Firma Daicel-Cytec, FFC 509 der Firma 3M, BBI-102, BBI-103, BBI-105, BBI-106, BBI-109, BBI-110, BBI-201, BBI, 301, BI-105, DPI-105, DPI-106, DPI-109, DPI-201, DTS-102, DTS-103, DTS-105, NDS-103, NDS-105, NDS-155, NDS-159, NDS-165, TPS-102, TPS-103, TPS-105, TPS-106, TPS-109, TPS-1000, MDS-103, MDS-105, MDS-109, MDS-205, MPI-103" MPI-105, MPI-106, MPI-109, DS-100, DS-101, MBZ-101, MBZ-201, MBZ-301, NAI-100, NAI-101, NAI-105, NAI-106, NAI-109, NAI-1002, NAI-1003, NAI-1004, NB-101, NB-201, NDI-101, NDI-105, NDI-106, NDI-109, PAI-01, PAI-101, PAI-106, PAI-1001, PI-105, PI-106, PI-109, PYR-100, SI-101, SI-105, SI-106 und SI-109 der Firma Midori Kagaku, Kayacure PCI-204, Kayacure PCI-205, Kayacure PCI-615, Kayacure PCI-625, Kayarad 220 und Kayarad 620, PCI-061T, PCI-062T, PCI-020T, PCI-022T der Firma Nippon Kayaku, TS-01 und TS-91 der Firma Sanwa Chemical, Deuteron UV 1240 der Firma Deuteron, Tego Photocompound 1465N der Firma Evonik, UV 9380 C-D1 der Firma GE Bayer Silicones, FX 512 der Firma Cytec, Silicolease UV Cata 211 der Firma Bluestar Silicones und Irgacure 250, Irgacure 261, Irgacure 270, Irgacure PAG 103, Irgacure PAG 121, Irgacure PAG 203, Irgacure PAG 290, Irgacure CGI 725, Irgacure CGI 1380, Irgacure CGI 1907 und Irgacure GSID 26-1 der Firma BASF.

Dem Fachmann sind weitere Systeme bekannt, die ebenfalls erfindungsgemäß einsetzbar sind. Photoinitiatoren werden unkombiniert oder als Kombination von zwei oder mehreren Photoinitiatoren eingesetzt.

Geeignet als optional enthaltene Klebharze sind Klebharze, wie sie dem Fachmann zum Beispiel aus dem Satas bekannt sind.

Besonders vorteilhaft enthält die Haftklebemasse zumindest eine Sorte eines vorzugsweise zumindest teilhydrierten Klebharzes, vorteilhaft solche, die mit der Elastomerkomponente beziehungsweise, sofern ein aus Hart- und Weichblöcken aufgebautes Copolymer eingesetzt wird, hauptsächlich mit dem Weichblock verträglich sind (Weichharze).

Es ist vorteilhaft, wenn entsprechendes Klebharz eine Erweichungstemperatur gemessen mittels Ring&Ball-Methode von größer 25 °C aufweist. Es ist darüber hinaus vorteilhaft, wenn ergänzend zumindest eine Sorte Klebharz mit einer Erweichungstemperatur von kleiner 20 °C eingesetzt wird. Hierüber kann, falls erforderlich, zum einen das klebtechnische Verhalten, zum anderen aber auch das Auffließverhalten auf dem Verklebungsuntergrund feineingestellt werden.

Für eher unpolare Elastomere können als Harze in der Haftklebemasse vorteilhaft partiell oder vollständig hydrierte Harze auf Basis von Kolophonium und Kolophoniumderivaten, hydrierte Polymerisate des Dicyclopentadiens, partiell, selektiv oder vollständig hydrierte Kohlenwasserstoffharze auf Basis von C₅-, C₅/C₉- oder C₉-Monomerströmen, Polyterpenharze auf Basis von α-Pinen und/oder ß-Pinen und/oder δ-Limonen und/oder Δ³-Caren, hydrierte Polymerisate von bevorzugt reinen C₈- und C₉-Aromaten eingesetzt werden. Vorgenannte Klebharze können sowohl allein als auch im Gemisch eingesetzt werden.

Dabei können sowohl bei Raumtemperatur feste als auch flüssige Harze zum Einsatz kommen. Um eine hohe Alterungs- und UV-Stabilität zu gewährleisten, sind hydrierte Harze mit einem Hydrierungsgrad von mindestens 90 %, vorzugsweise von mindestens 95 % bevorzugt.

Der Klebemasse können übliche Zuschlagstoffe wie Alterungsschutzmittel (Antiozonantien, Antioxidantien, Lichtschutzmittel usw.) zugesetzt sein.

Als weitere Additive können typischerweise genutzt werden:
- Plastifizierungsmittel wie zum Beispiel Weichmacheröle oder niedermolekulare flüssige Polymere wie zum Beispiel niedermolekulare Polybutene
- primäre Antioxidantien wie zum Beispiel sterisch gehinderte Phenole
- sekundäre Antioxidantien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel sowie
- Endblockverstärkerharze.

Der Anteil des Reaktivharzes in der Klebemasse beträgt von 15 bis 80 Gew.-%, insbesondere von 20 bis 70 Gew.-% und besonders bevorzugt von 25 bis 65 Gew.-%. Um eine gute Handhabbarkeit und elastische Klebmasse nach Aushärtung zu erzielen, ist ein bevorzugter Reaktivharzanteil 15 bis 35 Gew.-%, insbesondere 20 bis 30 Gew.-%. Für stärker vernetzte Verklebungen sind Reaktivharzanteile von 65 bis 80 Gew.-% bevorzugt. Besonders ausgewogen in Bezug auf Elastizität und Vernetzungsgrad sind Reaktivharzanteile von 35 bis 65 Gew.-%.

Es ist ferner möglich, dass der Reaktivharzanteil aus bis zu 100 % des oligomeren Alkoxysiloxans besteht. Für den Fall, dass das oligomere Alkoxysiloxan 100 % des Reaktivharzanteils ausmacht, ist also kein weiteres Reaktivharz in der Klebemasse enthalten. In diesem Fall entsprechen die bevorzugten Anteile an Alkoxysiloxan den vorstehend genannten für das Reaktivharz. Eine Verwendung von ausschließlich Alkoxysiloxan als Reaktivharz ist insbesondere dann vorteilhaft, wenn es sich bei dem oligomeren Alkoxysiloxan um ein höherkettiges Oligomer handelt, das heißt, wenn die durchschnittliche Anzahl der sich wiederholenden SiR₂-Gruppen größer als 5, vorzugsweise größer als 10 und insbesondere größer als 20 ist.

In einer bevorzugten Ausführung enthält das Reaktivharz Acrylate, Methacrylate und/oder Epoxidgruppen, insbesondere aliphatische und ganz besonders bevorzugt cycloaliphatische Epoxidgruppen.

Ganz besonders geeignet sind Klebemassen, in denen Reaktivharz und oligomeres Alkoxysiloxan gleichartige, insbesondere dieselben funktionellen polymerisierbaren Gruppen aufweisen. In diesem Fall können Reaktivharz und Alkoxysiloxan auf besonders gute Weise miteinander polymerisieren und vernetzen. Unter "gleichartigen funktionellen polymerisierbaren Gruppen" sind dabei solche zu verstehen, die einander chemisch sehr ähnlich sind wie zum Beispiel cyclische Ether mit verschiedener Ringgröße oder Acrylate und Methacrylate.

In einer bevorzugten Ausführung wird die Klebemasse kationisch, thermisch oder strahleninduziert ausgehärtet. Weiterhin ist es bevorzugt, dass die Klebemasse zumindest eine Sorte eines Photoinitiators für die kationische Härtung der vernetzbaren Komponente enthält.

Vorzugsweise ist das mindestens eine Elastomer aufgebaut aus zumindest einem olefinischen Monomer und/oder aus zumindest einem Polyurethan. Besonders bevorzugt ist das Elastomer mindestens ein Vinylaromatenblockcopolymer.

Als Siloxane im Sinne der Erfindung werden Verbindungen verstanden, die mindestens zwei über ein Sauerstoffatom verbundene SiR₂-Gruppen aufweisen. Unter dem Begriff "oligomer" im Sinne der Erfindung ist dabei zu verstehen, dass die Anzahl an sich wiederholenden SiR₂-Gruppen zwischen 2 und 40 beträgt. Die Verbindungen können kettenförmig oder ringförmig ausgebildet sein.

Oligomere Siloxane sind beispielsweise von Evonik (Dynasylan 6490, 6498, 6598,1175), Momentive (Coatosil MP200) oder Shin-Etsu (X-41-1053, X-41-1059A, X-41-1056) zu erhalten.

Die erfindungsgemäßen multifunktionellen oligomeren Siloxane enthalten als Reste R mindestens 2 unterschiedliche funktionelle Gruppen und haben einen Polymerisationsgrad ≥ 2. Besonders bevorzugt im Sinne dieser Erfindung ist hierbei eine der funktionellen Gruppen polymerisierbar (das heißt, ein Rest R ist zum Beispiel cyclischer Ether, Epoxid, Vinyl, Acrylat, Methacrylat, Isocyanat) und eine andere zur Reaktion mit Wasser fähig (das heißt, der andere Rest R ist zum Beispiel eine Alkoxygruppe wie Methoxy oder Ethoxy). Insbesondere geeignet zeigen sich multifunktionelle oligomere Siloxane, die eine mit dem Reaktivharz polymerisierbare Gruppe tragen. In manchen Fällen ist es von Vorteil, wenn die polymerisierbare Gruppe die gleiche, wie die des Reaktivharzes ist.

Beispiele für erfindungsgemäße multifunktionelle oligomere Siloxane sind Oligomere von 2-(3,4-Epoxycyclohexyl)ethylmethyldimethoxysilan, 2-(3,4-Epoxycyclohexyl)ethylmethyldiethoxysilan, gamma-(Glycidoxypropyl)trimethoxysilan, gamma-(Glycidoxypropyl)triethoxysilan sowie insbesondere von 2-(3,4-Epoxycyclohexyl)ethyltrimethoxysilan und 2-(3,4-Epoxycyclohexyl)ethyltriethoxysilan.

Besonders bevorzugt ist die erfindungsgemäße Klebemasse haftklebrig. Dies ermöglicht eine besonders gute Handhabbarkeit, da die Klebemasse auch vor der Vernetzung bereits an der zu verklebenden Stelle haftet.

Als Haftklebemassen werden Klebemassen bezeichnet, die bereits unter relativ schwachem Andruck eine dauerhafte Verbindung mit dem Haftgrund erlauben und nach Gebrauch im Wesentlichen rückstandsfrei vom Haftgrund wieder abgelöst werden können. Haftklebemassen wirken bei Raumtemperatur permanent haftklebrig, weisen also eine hinreichend geringe Viskosität und eine hohe Anfassklebrigkeit auf, so dass sie die Oberfläche des jeweiligen Klebegrunds bereits bei geringem Andruck benetzen. Die Verklebbarkeit entsprechender Klebemassen beruht auf ihren adhäsiven Eigenschaften und die Wiederablösbarkeit auf ihren kohäsiven Eigenschaften. Als Basis für Haftklebemassen kommen verschiedene Materialien in Frage.

Die vorliegende Erfindung betrifft darüber hinaus ein Klebeband, das auf einer Seite oder auf beiden Seiten mit der erfindungsgemäßen Klebemasse beschichtet ist. Dabei kann es sich bei dem Klebeband auch um ein Transferklebeband handeln. Ein Klebeband ermöglicht eine besonders einfache und präzise Verklebung und ist daher besonders geeignet.

Schließlich betrifft die vorliegende Erfindung die Verwendung der erfindungsgemäßen Klebemasse beziehungsweise des erfindungsgemäßen Klebebandes als Dichtmasse, insbesondere zur Verkapselung von Aufbauten in der organischen Elektronik. Wie oben ausgeführt, ist es in der organischen Elektronik von eminenter Bedeutung, die Komponenten vor Wasser(dampf) geschützt werden müssen. Aufgrund ihrer sehr guten Barriereeigenschaften sind die erfindungsgemäßen Klebemassen beziehungsweise Klebebänder in der Lage, einen entsprechenden Schutz zu gewähren. Aufgrund der hohen Transparenz und der geringen Schädigung der zu verkapselnden Elektronik sind die erfindungsgemäße Klebemasse und das erfindungsgemäße Klebeband neben einer Randverkapselung insbesondere auch für eine vollflächige Verkapselung von organischer Elektronik geeignet.

Der allgemeine Ausdruck "Klebeband" umfasst ein Trägermaterial, welches ein- oder beidseitig mit einer (Haft)klebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge (beispielsweise in Form von Umrandungen oder Begrenzungen einer (opto-) elektronischen Anordnung), Mehrschichtanordnungen und dergleichen. Dabei sind für verschiedene Anwendungen unterschiedlichste Träger wie zum Beispiel Folien, Gewebe, Vliese und Papiere mit den Klebmassen kombinierbar. Des Weiteren umfasst der Ausdruck "Klebeband" auch so genannte "Transferklebebänder", das heißt ein Klebeband ohne Träger. Bei einem Transferklebeband ist die Klebemasse vielmehr vor der Applikation zwischen flexiblen Linern aufgebracht, die mit einer Trennschicht versehen sind und/oder anti-adhäsive Eigenschaften aufweisen. Zur Applikation wird regelmäßig zunächst ein Liner entfernt, die Klebemasse appliziert und dann der zweite Liner entfernt. Die Klebemasse kann so direkt zur Verbindung zweier Oberflächen in (opto-) elektronischen Anordnungen verwendet werden.

Es sind aber auch Klebebänder möglich, bei denen nicht mit zwei Linern sondern mit einem einzigen doppelseitig trennend ausgerüstet Liner gearbeitet wird. Die Klebebandbahn ist dann an ihrer Oberseite mit der einen Seite eines doppelseitig trennend ausgerüsteten Liners abgedeckt, ihre Unterseite mit der Rückseite des doppelseitig trennend ausgerüsteten Liners, insbesondere einer benachbarten Windung auf einem Ballen oder einer Rolle.

Als Trägermaterial eines Klebebandes werden vorliegend bevorzugt Polymerfolien, Folienverbunde oder mit organischen und/oder anorganischen Schichten versehene Folien oder Folienverbunde eingesetzt. Derartige Folien/Folienverbunde können aus allen gängigen zur Folienherstellung verwendeten Kunststoffen bestehen, beispielhaft aber nicht einschränkend erwähnt seien:
Polyethylen, Polypropylen - insbesondere das durch mono-oder biaxiale Streckung erzeugte orientierte Polypropylen (OPP), Cyclische Olefin Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (PI).
Polyesterfolien weisen den Vorteil auf, dass sie für Temperaturstabilität sorgen und eine erhöhte mechanische Stabilität einbringen. Ganz besonders bevorzugt besteht daher eine Trägerschicht in einem erfindungsgemäßen Liner aus einer Polyesterfolie, beispielsweise aus biaxial verstrecktem Polyethylenterephthalat.

In einer bevorzugten Ausführungsform enthält das Trägermaterial auch eine Barrierefunktion gegen ein oder mehrere spezifische(s) Permeat(e), insbesondere gegen Wasserdampf und Sauerstoff. Eine derartige Barrierefunktion kann aus organischen oder anorganischen Materialien bestehen. Trägermaterialien mit Barrierefunktion sind in EP 2 078 608 A1 ausführlich dargestellt.

Besonders bevorzugt enthält das Trägermaterial mindestens eine anorganische Barriereschicht. Als anorganische Barriereschichten eignen sich besonders gut im Vakuum (zum Beispiel mittels Verdampfen, CVD, PVD, PECVD) oder unter Atmosphärendruck (zum Beispiel mittels Atmosphärenplasma, reaktiver Coronaentladung oder Flammenpyrolyse) abgeschiedene Metalle, wie Aluminium, Silber, Gold, Nickel oder insbesondere Metallverbindungen wie Metalloxide, -nitride oder -hydronitride, beispielsweise Oxide oder Nitride des Siliziums, des Bors, des Aluminiums, des Zirkoniums, des Hafniums oder des Tellurs oder Indium-Zinn-Oxid (ITO). Ebenfalls geeignet sind mit weiteren Elementen dotierte Schichten der vorstehend genannten Varianten.

Bei doppelseitig (selbst)klebenden Klebebändern können als obere und untere Schicht erfindungsgemäße Klebemassen gleicher oder verschiedener Art und/oder gleicher oder verschiedener Schichtdicke zur Anwendung kommen. Der Träger kann dabei auf einer oder beiden Seiten dem Stand der Technik entsprechend vorbehandelt sein, so dass beispielsweise eine Verbesserung der Klebemassenverankerung erzielt wird. Ebenso können eine oder beide Seiten mit einer funktionalen Schicht ausgerüstet sein, die beispielsweise als Sperrschicht fungieren kann. Die Haftklebemasseschichten können optional mit Trennpapieren oder Trennfolien eingedeckt werden. Alternativ kann auch nur eine Klebemasseschicht mit einem doppelseitig trennenden Liner eingedeckt sein.

In einer Variante ist in dem doppelseitig (selbst)klebenden Klebeband eine erfindungsgemäße Klebemasse vorgesehen sowie eine beliebige weitere, zum Beispiel eine solche, die besonders gut auf einem Abdecksubstrat haftet oder eine besonders gute Repositionierbarkeit zeigt.

Die Dicke der Haftklebemasse, die entweder als Transferklebeband oder auf einem flächigen Gebilde beschichtet vorliegt, beträgt bevorzugt zwischen 1 µm und 2000 µm, weiter bevorzugt zwischen 5 µm und 500 µm und besonders bevorzugt zwischen etwa 12 µm und 250 µm.

Schichtdicken zwischen 50 µm und 150 µm werden dann eingesetzt, wenn eine verbesserte Haftung auf dem Substrat und/oder eine dämpfende Wirkung erreicht werden soll.

Schichtdicken zwischen 1 µm und 50 µm reduzieren den Materialeinsatz. Jedoch kommt es zu einer Verringerung der Haftung auf dem Substrat.

Für doppelseitige Klebebänder gilt für die Klebemasse(n) ebenfalls, dass die Dicke der einzelnen Haftklebemasseschicht(en) bevorzugt 1 µm und 2000 µm, weiter bevorzugt zwischen 5 µm und 500 µm und besonders bevorzugt zwischen etwa 12 µm und 250 µm liegt. Kommt in doppelseitigen Klebebändern neben der einen erfindungsgemäßen Klebemasse eine weitere zum Einsatz, dann kann es auch vorteilhaft sein, wenn ihre Dicke oberhalb 150 µm liegt.

Klebebänder, die ein- oder beidseitig mit Klebstoffen beschichtet sind, werden am Ende des Herstellungsprozesses zumeist zu einer Rolle in Form einer archimedischen Spirale aufgewickelt. Um bei doppelseitig klebenden Klebebändern zu verhindern, dass die Klebemassen miteinander in Kontakt kommen, oder um bei einseitig klebenden Klebebändern eine Verklebung der Klebemasse auf dem Träger zu verhindern, werden die Klebebänder vor dem Wickeln mit einem Abdeckmaterial (auch als Trennmaterial bezeichnet) eingedeckt, das zusammen mit dem Klebeband aufgewickelt wird. Dem Fachmann sind derartige Abdeckmaterialien unter den Namen Liner oder Releaseliner bekannt. Neben der Abdeckung von ein- oder doppelseitig klebenden Klebebändern werden Liner auch zur Eindeckung von reinen Klebemassen (Transferklebeband) und Klebebandabschnitten (zum Beispiel Etiketten) eingesetzt.

Ein weiterer Hauptanspruch betrifft ein Verfahren zum Schutz einer auf einem Substrat angeordneten organischen elektronischen Anordnung, wobei eine Abdeckung derart auf die elektronische Anordnung aufgebracht wird, dass die elektronische Anordnung zumindest teilweise durch die Abdeckung überdeckt wird, wobei weiterhin die Abdeckung zumindest teilflächig auf dem Substrat und/oder auf der elektronischen Anordnung verklebt wird, wobei die Verklebung mittels zumindest einer Schicht einer Klebemasse bewirkt wird. Die Klebemassenschicht liegt dabei insbesondere als Schicht eines Klebebandes vor.

Das erfindungsgemäße Verfahren kann vorteilhaft derart geführt werden, dass zunächst die (Haft-)Klebstoffschicht, gegebenenfalls als Bestandteil eines weitere Schichten umfassenden doppelseitig klebenden Klebebandes, und in einem nachfolgenden Schritt die Abdeckung auf das Substrat und/oder die elektronische Anordnung aufgebracht wird. In einer weiteren vorteilhaften Vorgehensweise werden die (Haft-)Klebstoffschicht, gegebenenfalls als Bestandteil eines weitere Schichten umfassenden doppelseitig klebenden Klebebandes, und die Abdeckung gemeinsam auf das Substrat und/oder die elektronische Anordnung aufgebracht.
Beim erfindungsgemäßen Verfahren kann das Transferklebeband somit zunächst mit dem Substrat beziehungsweise der elektronischen Anordnung verbunden werden oder zuerst mit der Abdeckung. Bevorzugt ist jedoch, zunächst das Transferklebeband mit der Abdeckung zu verbinden, da somit eine Baugruppe der elektronischen Funktionseinheit unabhängig von der elektronischen Anordnung vorgefertigt und als Ganzes zulaminiert werden kann.

Vorteilhaft kann das erfindungsgemäße Verfahren derart geführt werden, dass die Abdeckung und/oder die (Haft-)Klebstoffschicht, insbesondere als Transferklebeband, die elektronische Anordnung vollständig überdecken, da dann die lichtstreuende Wirkung die gesamte Fläche der Anordnung betrifft..

Durch die vollflächige Lamination des Transferklebebands über die elektronische Anordnung wird zudem die Einwirkung möglicherweise im Gasraum einer lediglich randverkapselten Anordnung eingeschlossener schädlicher Permeate ausgeschlossen, da es keinen Gasraum gibt.

Das erfindungsgemäße Verfahren wird bevorzugt derart geführt, dass auch ein Bereich des Substrats um die elektronische Anordnung herum durch die Abdeckung ganz oder teilweise überdeckt wird, wobei das Klebeband zur Verklebung die elektronische Anordnung dabei vollflächig bedecken kann und bevorzugt ebenfalls einen Bereich des Substrats um die elektronische Anordnung herum bedeckt, bevorzugt denselben Bereich wie die Abdeckung - oder teilflächig aufgebracht sein kann, etwa rahmenförmig um die elektronische Anordnung herum - bevorzugt in dem Bereich, der auch durch die Abdeckung bedeckt wird -, und gegebenenfalls zusätzlich in einem Randbereich auf der elektronischen Anordnung.

Ein weiterer Gegenstand der Erfindung ist eine (opto-)elektronische Anordnung umfassend zumindest eine (opto-)elektronische Struktur und eine Schicht eines erfindungsgemäßen Klebstoffs, wobei die Klebstoffschicht die (opto-)elektronische Struktur vollflächig überdeckt.

Weitere Einzelheiten, Merkmale und Vorteile der vorliegenden Erfindung werden nachfolgend anhand bevorzugter Ausführungsbeispiele näher erläutert. In der Zeichnung zeigt
Abb. 7 eine (opto-)elektronische Anordnung nach dem Stand der Technik in schematischer Darstellung,
Abb. 8 eine erste erfindungsgemäße (opto-)elektronische Anordnung in schematischer Darstellung,
Abb. 9 eine zweite erfindungsgemäße (opto-)elektronische Anordnung in schematischer Darstellung.

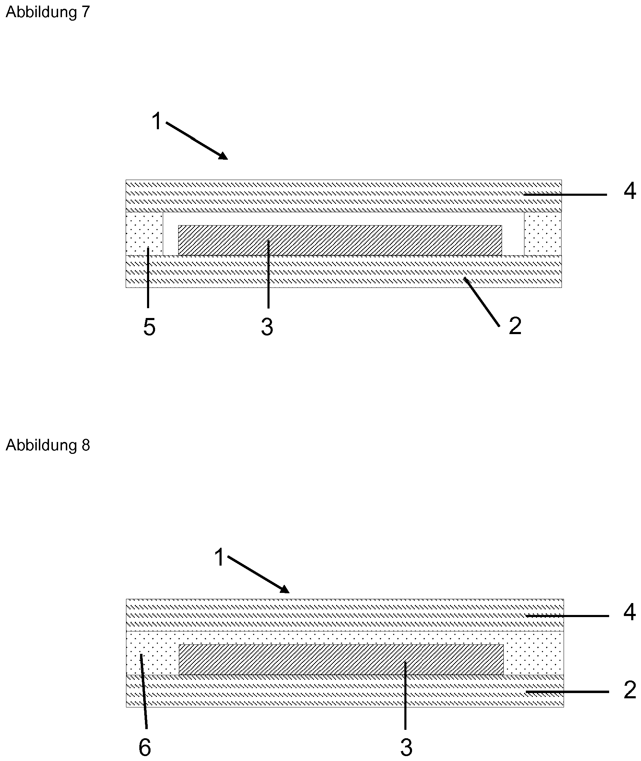

Abb. 7 zeigt eine erste Ausgestaltung einer organischen elektronischen Anordnung 1 nach dem Stand der Technik. Diese Anordnung 1 weist ein Substrat 2 auf, auf dem eine elektronische Struktur 3 angeordnet ist. Das Substrat 2 selbst ist als Barriere für Permeate ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.

Um die elektronische Struktur 3 auch zur Seite hin zu kapseln und gleichzeitig die Abdeckung 4 mit der elektronischen Anordnung 1 im Übrigen zu verbinden, ist ein Klebstoff 5 umlaufend neben der elektronischen Struktur 3 auf dem Substrat 2 vorgesehen. Dabei ist es unerheblich, ob der Klebstoff zunächst mit dem Substrat 2 verbunden wurde oder zuerst mit der Abdeckung 4. Der Klebstoff 5 verbindet die Abdeckung 4 mit dem Substrat 2. Durch eine entsprechend dicke Ausgestaltung ermöglicht der Klebstoff 5 zudem die Beabstandung der Abdeckung 4 von der elektronischen Struktur 3.

Bei dem Klebstoff 5 handelt es sich um eine solche nach dem Stand der Technik, also einen Klebstoff mit hoher Permeationsbarriere, der zudem zu einem hohen Anteil mit Gettermaterial gefüllt sein kann. Die Transparenz des Klebstoffs ist in diesem Aufbau nicht relevant.

Ein Transferklebeband würde vorliegend in Form eines Stanzlings bereitgestellt, welcher aufgrund seiner filigranen Geometrie schwieriger handzuhaben ist als ein im Wesentlichen vollflächig appliziertes Transferklebeband.

Abb. 8 zeigt eine erfindungsgemäße Ausgestaltung einer (opto-)elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun der erfindungsgemäße Klebstoff, zum Beispiel in der Ausführung als Transferklebeband 6 vollflächig angeordnet. Die elektronische Struktur 3 wird somit von oben vollständig durch das Transferklebeband 6 gekapselt. Auf das Transferklebeband 6 ist sodann eine Abdeckung 4 aufgebracht. Bei dem Transferklebeband 6 handelt es sich um ein solches auf Basis des erfindungsgemäßen Transferklebebands wie es vorstehend in allgemeiner Form beschrieben wurde und nachfolgend in Ausführungsbeispielen näher dargelegt ist. Das Transferklebeband besteht in der dargestellten Ausführung nur aus einer Schicht eines erfindungsgemäßen Klebstoffs.

Die Abdeckung 4 muss im Gegensatz zu der vorherigen Ausgestaltung nicht zwingend die hohen Barriereanforderungen erfüllen, da bei vollflächiger Überdeckung der elektronischen Anordnung durch das Transferklebeband die Barriere bereits durch den Klebstoff bereitgestellt wird. Die Abdeckung 4 kann beispielsweise lediglich eine mechanische Schutzfunktion wahrnehmen, sie kann aber auch zusätzlich als Permeationsbarriere vorgesehen sein.

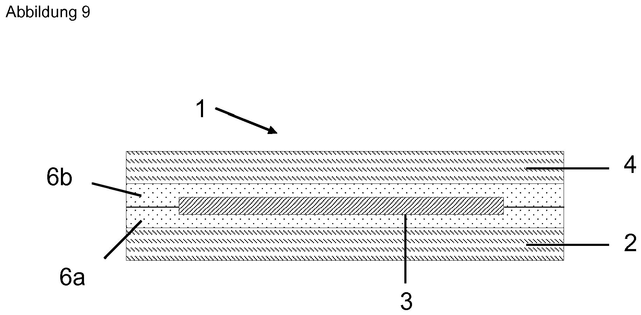

Abb. 9 zeigt eine alternative Ausgestaltung einer (opto-)elektronischen Anordnung 1. Im Gegensatz zu den vorherigen Ausgestaltungen sind nun zwei Transferklebebänder 6a, b vorgesehen, die vorliegend identisch ausgebildet sind, aber auch unterschiedlich sein können. Das erste Transferklebeband 6a ist vollflächig auf dem Substrat 2 angeordnet. Auf dem Transferklebeband 6a ist die elektronische Struktur 3 vorgesehen, die durch das Transferklebeband 6a fixiert wird. Der Verbund aus Transferklebeband 6a und elektronischer Struktur 3 wird dann mit dem weiteren Transferklebeband 6b vollflächig überdeckt, so dass die elektronische Struktur 3 von allen Seiten durch die Transferklebebänder 6a, b gekapselt ist. Oberhalb des Transferklebebands 6b ist wiederum die Abdeckung 4 vorgesehen.

In dieser Ausgestaltung müssen somit weder das Substrat 2 noch die Abdeckung 4 zwingend Barriereeigenschaften aufweisen. Sie können aber dennoch vorgesehen sein, um die Permeation von Permeaten zur elektronischen Struktur 3 weiter einzuschränken.

Insbesondere im Hinblick auf die Abb. 8 und 9 wird darauf hingewiesen, dass es sich vorliegend um schematische Darstellungen handelt. Aus den Darstellungen ist insbesondere nicht ersichtlich, dass das Transferklebeband hier und vorzugsweise jeweils eine homogene Schichtdicke aufweist. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Gegebenenfalls kann jedoch auch eine Anpassung an den Untergrund erfolgen, insbesondere dann, wenn die Applikation unter Vakuum durchgeführt wird. Zudem wird die Klebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 µm dick).

Auch ist ein direkter Kontakt des Klebstoffs mit dem elektronischen Aufbau nicht zwingend vorzusehen. Es können auch weitere Schichten dazwischen angeordnet sein wie zum Beispiel eine Dünnschichtverkapselung des elektronischen Aufbaus oder Barrierefilme.

Die Dicke des Transferklebebands kann alle üblichen Dicken umfassen, also etwa von 1 µm bis zu 3000 µm. Bevorzugt wird eine Dicke zwischen 25 und 100 µm, da in diesem Bereich Klebkraft und Handlingeigenschaften besonders positiv ausfallen. Ein weiterer bevorzugter Bereich ist eine Dicke von 3 bis 25 µm, da in diesem Bereich die Menge von durch die Klebefuge permeierenden Stoffen allein durch die kleine Querschnittsfläche der Klebefuge in einer Verkapselungsanwendung gering gehalten werden kann.

Zur Herstellung eines erfindungsgemäßen Transferklebebands wird der Träger des Klebebands oder der Liner einseitig mit dem erfindungsgemäßen Klebstoff aus Lösung oder Dispersion oder 100 %ig (zum Beispiel Schmelze) beschichtet oder bedruckt, oder das Klebeband wird durch (Co-)Extrusion hergestellt. Alternativ ist eine Herstellung durch Transfer einer erfindungsgemäßen Klebstoff-Schicht durch Kaschieren auf eine Trägermaterial oder einen Liner möglich. Die Klebestoffschicht kann durch Wärme oder energiereiche Strahlen vernetzt werden.

Bevorzugt findet dieser Herstellprozess in einer Umgebung statt, in der das spezifische Permeat nur in geringer Konzentration oder nahezu gar nicht enthalten ist. Als Beispiel kann eine relative Luftfeuchtigkeit von weniger als 30 %, bevorzugt von weniger als 15 % genannt werden.

### Beispiele

### Messmethoden

### Bestimmung der Durchbruchzeit (Lebensdauertest)

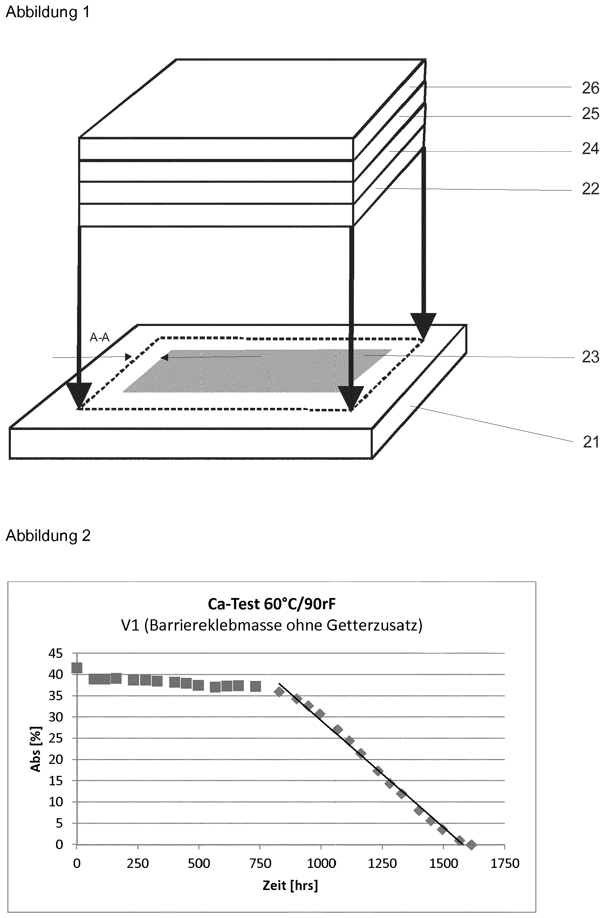

Als ein Maß für die Bestimmung der Lebensdauer eines elektronischen Aufbaus wurde ein Calciumtest herangezogen. Dieser ist in der Abbildung 1 gezeigt. Dazu wird im Vakuum eine 10 x 10 mm² große, dünne Calciumschicht 23 auf eine Glasplatte 21 abgeschieden und danach unter Stickstoffatmosphäre gelagert. Die Dicke der Calciumschicht 23 liegt bei etwa 100 nm. Für die Verkapselung der Calciumschicht 23 wird ein Klebeband (23 x 23 mm²) mit der zu testenden Klebemasse 22 sowie einer Dünnglasscheibe 24 (35 µm, Firma Schott) als Trägermaterial verwendet. Zur Stabilisierung war die Dünnglasscheibe mit einer 100 µm dicken PET-Folie 26 mittels eines 50 µm dicken Transferklebebands 25 einer optisch hochtransparenten Acrylathaftklebemasse laminiert. Die Klebemasse 22 wird so auf der Glasplatte 21 appliziert, dass die Klebemasse 22 den Calciumspiegel 23 mit einem allseitig überstehenden Rand von 6,5 mm (A-A) abdeckt. Aufgrund des undurchlässigen Glasträgers 24 wird nur die Permeation durch den Haftkleber oder entlang der Grenzflächen ermittelt.

Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654 bis 659, und von M. E. Gross et al. in "46th Annual Technical Conference Proceedings-Society of Vacuum Coaters", 2003, Seiten 89 bis 92, beschrieben sind. Dabei wird die Lichttransmission der Calciumschicht überwacht, welche durch die Umwandlung in Calciumhydroxid und Calciumoxid zunimmt. Diese erfolgt beim beschriebenen Prüfaufbau vom Rand her, so dass sich die sichtbare Fläche des Calciumspiegels verringert. Es wird die Zeit bis zur Halbierung der Lichtabsorption des Calciumspiegels als Lebensdauer bezeichnet. Durch die Methode werden dabei sowohl der Abbau der Fläche des Calciumspiegels vom Rand aus und durch punktuellen Abbau in der Fläche als auch die homogene Verringerung der Schichtdicke des Calciumspiegels durch vollflächigen Abbau erfasst.

Als Messbedingungen wurden 60 °C und 90 % relative Luftfeuchte gewählt. Die Muster wurden mit einer Schichtdicke der Haftklebemasse von 50 µm vollflächig und blasenfrei verklebt. Der Abbau des Ca-Spiegels wird über Transmissionsmessungen verfolgt. Die Durchbruchzeit ist definiert als diejenige Zeit, die Feuchtigkeit benötigt, um die Strecke bis zum Ca zurückzulegen. Bis zum Erreichen dieser Zeit bei 60°C 90% r.F. ändert sich die Transmission des Ca-Spiegels nur marginal.

### MMAP und DACP

MMAP ist der gemischte-Methylcyclohexan-Anilin-Trübungspunkt, der unter Verwendung eines modifizierten ASTM C 611-Verfahrens bestimmt wird. Methylcyclohexan ist für das in dem Standard-Prüfverfahren verwendete Heptan eingesetzt. Das Verfahren verwendet Harz/Anilin/Methylcyclohexan in einem Verhältnis von 1/2/1 (5 g/10 ml/5 ml) und der Trübungspunkt wird durch Abkühlen einer erhitzten, klaren Mischung der drei Komponenten, bis die vollständige Trübung gerade eintritt, bestimmt.

Der DACP ist der Diaceton-Trübungspunkt und wird durch Abkühlen einer erhitzten Lösung von 5 g Harz, 5 g Xylol und 5 g Diacetonalkohol bis zu dem Punkt bestimmt, bei welchem die Lösung trübe wird.

### Wasserdampfpermeationsrate

Die WVTR wird dabei bei 38°C und 90% relativer Luftfeuchtigkeit nach ASTM F-1249, die OTR bei 23°C und 50% relativer Luftfeuchtigkeit nach DIN 53380-Teil3 gemessen. Es wird jeweils eine Doppelbestimmung durchgeführt und der Mittelwert gebildet. Der angegebene Wert ist auf eine Dicke von 50 µm normiert / ist bezogen auf die jeweilige Dicke des vermessenen Prüflings.

Die Transferklebebänder wurden für die Messungen auf eine hochpermeable Polysulfon-Membran (erhältlich von der Firma Sartorius) geklebt, die selbst keinen Beitrag zur Permeationsbarriere liefert. Die Messungen wurden an vernetzten Klebebändern vorgenommen.

### Molekulargewicht:

Die Molekulargewichtsbestimmungen der zahlenmittleren Molekulargewichte Mₙ und der gewichtsmittleren Molekulargewichte M_{w} erfolgten mittels Gelpermeationschromatographie (GPC). Als Eluent wurde THF (Tetrahydrofuran) mit 0,1 Vol.-% Trifluoressigsäure eingesetzt. Die Messung erfolgte bei 25 °C. Als Vorsäule wurde PSS-SDV, 5 µ, 10³ Å, ID 8,0 mm x 50 mm verwendet. Zur Auftrennung wurden die Säulen PSS-SDV, 5 µ, 10³ sowie 10⁵ und 10⁶ mit jeweils ID 8,0 mm x 300 mm eingesetzt. Die Probenkonzentration betrug 4 g/l, die Durchflussmenge 1,0 ml pro Minute. Es wurde gegen Polystyrol-Standards gemessen.

### Erweichungstemperatur

Die Reaktiv- beziehungsweise Klebharzerweichungstemperatur wird nach der einschlägigen Methodik durchgeführt, die als Ring and Ball bekannt ist und nach ASTM E28 standardisiert ist.

Zur Bestimmung der Klebharzerweichungstemperatur der Harze kommt ein Ring-Kugel-Automat HRB 754 der Firma Herzog zum Einsatz. Harzmuster werden zunächst fein gemörsert. Das resultierende Pulver wird in einen Messingzylinder mit Bodenöffnung (Innendurchmesser am oberen Teil des Zylinders 20 mm, Durchmesser der Bodenöffnung des Zylinders 16 mm, Höhe des Zylinders 6 mm) gefüllt und auf einem Heiztisch geschmolzen. Die Befüllmenge wird so gewählt, dass das Harz nach dem Schmelzen den Zylinder ohne Überstand voll ausfüllt.

Der resultierende Probekörper wird samt Zylinder in die Probehalterung des HRB 754 eingelegt. Zur Befüllung des Temperierbads wird Glycerin verwendet, sofern die Klebharzerweichungstemperatur zwischen 50 °C und 150 °C liegt. Bei niedrigeren Klebharzerweichungstemperaturen kann auch mit einem Wasserbad gearbeitet werden. Die Prüfkugeln haben einen Durchmesser von 9,5 mm und wiegen 3,5 g. Entsprechend der HRB 754 Prozedur wird die Kugel oberhalb des Probekörpers im Temperierbad angeordnet und auf dem Probekörper abgelegt. 25 mm unter dem Zylinderboden befindet sich eine Auffangplatte, 2 mm über dieser eine Lichtschranke. Während des Messvorgangs wird die Temperatur mit 5 °C/min erhöht. Im Temperaturbereich der Klebharzerweichungstemperatur beginnt sich die Kugel durch die Bodenöffnung des Zylinders zu bewegen, bis sie schließlich auf der Auffangplatte zum Stehen kommt. In dieser Position wird sie von der Lichtschranke detektiert und zu diesem Zeitpunkt die Temperatur des Temperierbads registriert. Es findet eine Doppelbestimmung statt. Die Klebharzerweichungstemperatur ist der Mittelwert aus den beiden Einzelmessungen.

### Gelgehalt

Der Gelgehalt wurde gravimetrisch bestimmt. Dazu wird die Klebmasse strahleninduziert gehärtet. Die ausgehärtete Klebmasse wird ausgewogen (M₀) und dann 24h in einem Soxhlett-Extraktor mit Toluol extrahiert. Der trockene Rückstand wird erneut gewogen (M₁). Der Gelgehalt wird in Prozent angegeben und errechnet sich aus GG = (M₁ / M₀)*100

### Klebemassenschichten:

Zur Herstellung von Klebemasseschichten wurden verschiedene Klebemassen aus einer Lösung auf einen konventionellen Liner (silikonisierte Polyesterfolie) mittels eines Laborstreichgeräts aufgebracht und getrocknet. Die Klebemassenschichtdicke nach dem Trocknen beträgt 50±5 µm. Die Trocknung erfolgte jeweils zunächst bei RT für 10 Minuten und 10 Minuten bei 120 °C in einem Labortrockenschrank. Die getrockneten Klebemasseschichten wurden jeweils unverzüglich nach dem Trocknen mit einem zweiten Liner (silikonisierte Polyesterfolie mit geringerer Trennkraft) auf der offenen Seite laminiert.

**Verwendete Rohstoffe:**

| | |
|---|---|
| Sibstar 62M | SiBS (Polystyrol-block-Polyisobutylen-Blockcopolymer) der Firma Kaneka mit 20 Gew.-% Blockpolystyrolgehalt. Enthält zum Teil auch Diblockcopolymere. |
| Uvacure 1500 | cycloaliphatisches Diepoxid der Firma Cytec ((3,4-epoxycyclohexane) methyl 3,4-epoxycyclohexylcarboxylate) |
| Escorez 5300 | ein vollhydriertes Kohlenwasserstoffharz der Firma Exxon (Ring and Ball 105 °C, DACP = 71, MMAP = 72) |
| Polyacrylat | Acrylatcopolymer aus 2-Hydroxyethylacrylat, 2 Ethylhexylacrylat und C-17-Acrylat, Mₙ = 884000 g / mol |
| Dynasylan 9896 Vinyltrimethoxysilan | Oligomeres Propyltrimethoxysiloxan |
| 2-(3,4-Epoxycyclohexyl)ethyltrimethoxysilan | Trimethoxysilan mit cycloaliphatischer Epoxidgruppe |
| Dynasylan 6490 Triarylsulfoniumhexafluoroantimonat | Oligomeres Vinyltrimethoxysiloxan kationischer Fotoinitiator von der Firma Sigma-Aldrich Der Photoinitiator weist ein Absorptionsmaximum im Bereich 320 nm bis 360 nm auf und lag als 50 Gew.-%-ige Lösung in Propylencarbonat vor |

Das Polyacrylat (Acrylatcopolymer aus 2-Hydroxyethylacrylat, 2 Ethylhexylacrylat und C-17-Acrylat, Mₙ = 884000 g / mol) wurde nach folgender Vorschrift hergestellt:
Ein für radikalische Polymerisationen konventioneller 2 L Glasreaktor wurde mit 40 g 2-Hydroxyethylacrylat, 240 g 2 Ethylhexylacrylat, 120 g C17-Acrylat (dreifach verzweigte Seiten mit C3- C4 Kettensegmenten, BASF SE), 133 g Siedegrenzbenzin 69/95 und 133 g Aceton befüllt. Nachdem 45 Minuten Stickstoffgas unter Rühren durch die Reaktionslösung geleitet worden war, wurde der Reaktor auf 58 °C geheizt und 0,2 g Vazo 67 (Fa. DuPont) hinzugegeben. Anschließend wurde das äußere Heizbad auf 75°C erwärmt und die Reaktion konstant bei dieser Außentemperatur durchgeführt. Nach 1 h Reaktionszeit wurden 50 g Toluol hinzugegeben. Nach 2.5 h wurde mit 100 g Aceton verdünnt. Nach 4 h Reaktionszeit wurden nochmals 0,2 g Vazo 67 hinzugegeben. Nach 7 h Polymerisationszeit wurde mit 100 g Siedegrenzbenzin 60/95, nach 22 h mit 100 g Aceton verdünnt. Nach 24 h Reaktionszeit wurde die Polymerisation abgebrochen und das Reaktionsgefäß auf Raumtemperatur abgekühlt. Das Molekulargewicht Mₙ betrug 884000 g/mol.

Als Copolymer wurde ein Polystyrol-block-Polyisobutylen Blockcopolymer der Firma Kaneka ausgewählt. Der Anteil an Styrol im Gesamtpolymer beträgt 20 Gew.-%. Es wurde Sibstar 62M verwendet. Die Molmasse M_{w} beträgt 60.000 g/mol. Die Glasübergangstemperatur der Polystyrolblöcke betrug 100 °C und der Polyisobutylenblöcke - 60 °C. Als Klebharz kam Escorez 5300 (Ring and Ball 105 °C, DACP = 71, MMAP = 72) der Firma Exxon, ein vollhydriertes Kohlenwasserstoffharz zum Einsatz. Als Reaktivharz wurde Uvacure 1500 der Firma Dow ausgewählt, ein cycloaliphatisches Diepoxid. Diese Rohstoffe sowie ggf. das Siloxan wurden in einem Gemisch aus Toluol (300 g), Aceton (150 g) und Siedegrenzenbenzin 60/95 (550 g) gelöst, so dass eine 50 Gew.-% Lösung entsteht.

Anschließend wurde der Lösung ein Photoinitiator zugesetzt. Der Photoinitiator lag als 50 Gew.-%ige Lösung in Propylencarbonat vor. Der Photoinitiator weist ein Absorptionsmaximum im Bereich 320 nm bis 360 nm auf.

Die genaue Zusammensetzung der einzelnen Beispiele V1 bis V4 und V5 beziehungsweise K1 ist der Tabelle 1 zu entnehmen.

**Tabelle 1:**

| **Beispiel:** | **K1** | **V1** | **V2** | **V3** | **V4** | **V5** |
|---|---|---|---|---|---|---|
| | Gew.-Teile | Gew.-Teile | Gew.-Teile | Gew.-Teile | Gew.-Teile | Gew.-Teile |
| SiBStar 62M | 35,5 | 37,5 | 35,5 | 35,5 | 35,5 | |
| Uvacure 1500 | 24 | 25 | 24 | 24 | 24 | 20 |
| Polyacrylat | 0 | 0 | 0 | 0 | 0 | 75 |
| Vinyltrimethoxysilan | 0 | 0 | 5 | 0 | 0 | 0 |
| Dynasylan 9896 (Oligomeres aus Propyltrimethoxysilan) | 0 | 0 | 0 | 5 | 0 | 5 |
| 2-(3,4-Epoxycyclohexyl)ethyltrimethoxysilan (TME) | 0 | 0 | 0 | 0 | 5 | 0 |
| Dynasylan 6490 (Oligomeres aus Vinyl Trimethoxysilan) | 5 | 0 | 0 | 0 | 0 | 0 |
| Escorez 5300 | 35,5 | 37,5 | 35,5 | 35,5 | 35,5 | |
| Triarylsulfoniumhexafluoroantimonat | 0,1 | 0,1 | 0,1 | 0,1 | 0,1 | 0,1 |

Mittels eines Rakelverfahrens wurde die Formulierung aus Lösung auf einen silikonisierten PET-Liner beschichtet und bei 120 °C für 15 min getrocknet. Der trockene Masseauftrag betrug 50 g/m². Das Muster wurde mit einer weiteren Lage eines silikonisierten aber leichter trennenden PET-Liners eingedeckt.

Die Muster wurden in eine Glove-Box eingeschleust. Ein Teil der Muster wurde auf einem mit Ca bedampften Glassubstrat mit einem Gummianroller blasenfrei laminiert. Darauf wurde der zweite PET-Liner ausgedeckt und eine Lage eines Dünnglases auflaminiert. Anschließend wurde durch das Abdeckglas mittels UV-Licht gehärtet (Dosis: 80 mJ/cm²; Lampentyp: undotierter Quecksilberstrahler). Dieses Muster wurde für den Lebensdauertest verwendet.

Die Graphen für den Verlauf des Lebensdauertests sind in den Abbildungen 2 bis 6 wiedergegeben.

Dabei zeigt Abbildung 2 die Klebemasse gemäß Beispiel V1, das heißt die Klebemasse ohne Getterzusatz.

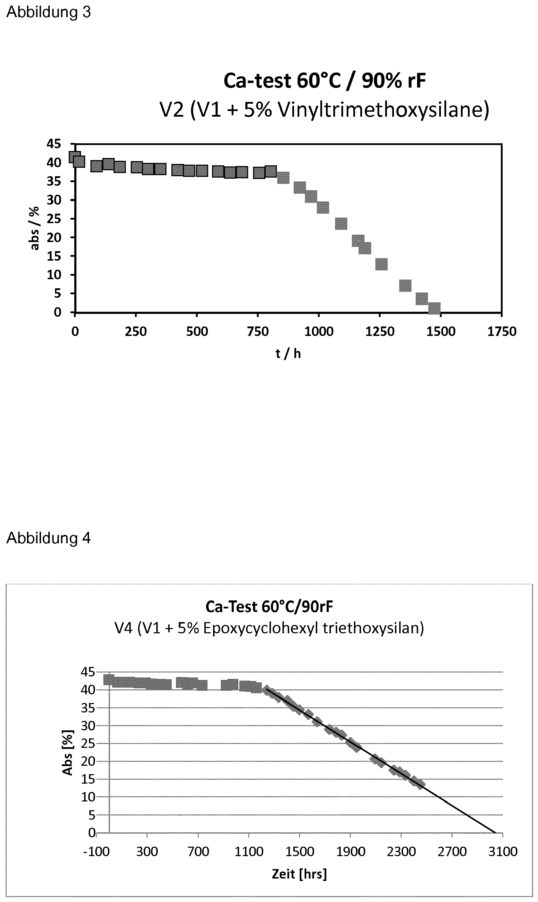

Abbildung 3 zeigt die Klebemasse gemäß Beispiel V2, das heißt eine Klebemasse mit einem multifunktionellen Getter, der jedoch monomer und nicht oligomer vorliegt.

Abbildung 4 zeigt die Klebemasse gemäß Beispiel V4, das heißt ebenfalls eine Klebemasse mit einem multifunktionellen Getter, der jedoch monomer und nicht oligomer vorliegt.

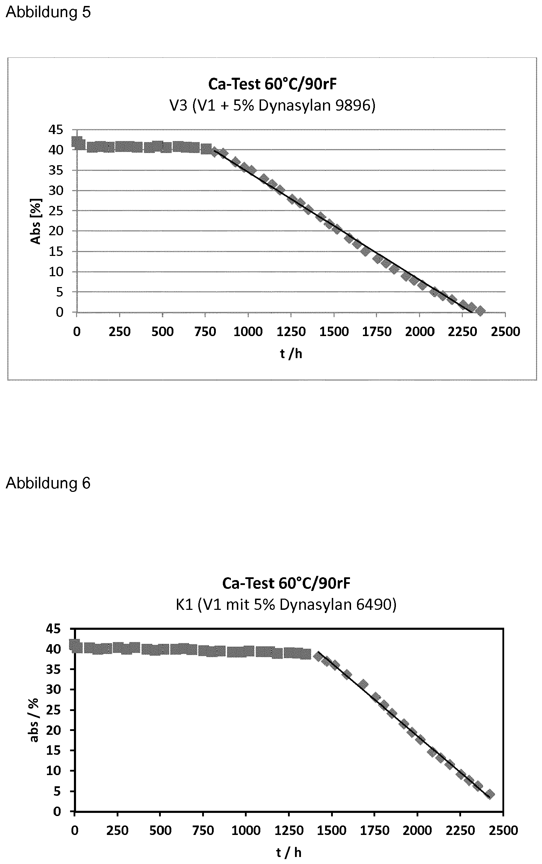

Abbildung 5 zeigt die Klebemasse gemäß Beispiel V3, das heißt eine Klebemasse mit einem oligomeren Getter, der jedoch nicht multifunktionell ist, das heißt keine Vernetzung ermöglicht.

Abbildung 6 schließlich zeigt die erfindungsgemäße Klebemasse gemäß Beispiel K1, die multifunktionell ist und oligomer vorliegt.

Die Ergebnisse der Feuchtigkeitspermeationsmessung der Basismasse (V1) und einer Acrylatmasse (V5) ohne Zugabe eines Wasserfängers sind in Tabelle 2 wiedergegeben.

**Tabelle 2:**

| | **V1** | **V5** |
|---|---|---|
| **WVTR / g m⁻²d⁻¹** | 7 | 712 |

Dies zeigt, dass die hier beschriebene Basismasse anders als V5 einen sehr niedrigen WVTR-Wert (kleiner 100g/m²d, bevorzugt weniger als 50g/m²d insbesondere weniger als 15g/m²d) hat. Vergleicht man dieses Ergebnisse mit den erzielten Barriereeigenschaften, so ist festzustellen, dass lediglich die erfindungsmäßigen Massen mit weniger als 100g/m²d eine Durchbruchzeit (lag-time) aufweisen (s. Tabelle 3).

Die ermittelten Durchbruchzeiten von Wasser im Ca-Test sind in der folgenden Tabelle 3 aufgeführt:

**Tabelle 3:**

| **Bezeichnung** | **Durchbruchzeit / h** | **Gelgehalt / %** |
|---|---|---|
| V1 (ohne zusätzlichen Getter) | 750 | 26 |
| V2 (5% Vinyltrimethoxysilan) | 800 | 29 |
| V3 (5% Dynasylan 9896) | 780 | 23 |
| V4 (5% TME) | 1150 | 30 |
| V5 (5% Dynasylan 9896) | 0 | 24 |
| K1 (5% Dynasylan 6490) | 1400 | 31 |

Der Tabelle ist zu entnehmen, dass die Durchbruchzeit von Wassermolekülen durch eine Haftklebmasse, enthaltend ein multifunktionelles Alkoxysiloxan mit polymerisierbaren und wasserbindenden Gruppen, deutlich verbessert wird. Grundsätzlich lässt sich die Durchbruchzeit von Barriereklebemassen mit Alkoxysilanverbindungen (V4) im Vergleich zu Barriereklebemassen ohne Zusatz solcher Moleküle erhöhen (V1). Die Performance des multifunktionellen Siloxangetters liegt jedoch noch darüber, obwohl die relative Menge an wasserfangenden Gruppen niedriger ist (K1). Die relative Menge an wasserfangenden Gruppen ist niedriger, da pro Wiederholungseinheit statistisch lediglich eine Alkoxysilangruppen enthalten ist. Im Gegensatz dazu enthalten Vinyltrimethoxysilan und TME jeweils 3 Alkoxysilangruppen.

Die polymerisierbaren Vinylgruppen werden im Aushärtungsschritt in das Epoxidnetzwerk mit eingebunden, sodass es im Vergleich zu V1 nicht zu einer Erniedrigung der Netzpunktdichte kommt. Klebmassen mit dem monomeren Analogon Vinyltrimethoxysilan (V2) zeigen im Vergleich zur Klebmassen ohne Getterzusatz keine signifikante Verbesserung der Durchbruchzeit von Wasser. Auch hier kommt es wie bei V4 zu einer Reduktion der Netzdichte im Vergleich zu V1. Dies bewirkt, dass die Diffusion aufgrund des weniger engen Netzwerks erleichtert wird und somit trotz der Getterfunktion die Performance nicht so deutlich steigt wie mit dem zusätzlich als Vernetzer fungierenden multifunktionellen oligomeren Siloxan in K1. V3 enthält ebenfalls ein oligomeres Siloxan (Oligomeres aus Propyltrimethoxysilan), welches jedoch nicht multifunktionell ist und demnach im Aushärtungsschritt nicht härtet. Somit wirkt dieses als eine Art Weichmacher und ermöglicht auch eine leichtere Permeation von Wassermolekülen, sodass die Performance der Barriereklebemasse trotz der Alkoxysilangruppen vergleichbar mit der Klebmasse ohne Getteradditivierung ist.

Dies zeigt eindeutig den Vorteil der erfindungsgemäßen Klebemasse, denn nur, wenn der Getter mehr als eine polymerisierbare Gruppe hat und mehr als eine wasserfangende Gruppe, fungiert er als Wasserfänger und Vernetzer. Die Zugabe des Getters erhöht somit nicht die Permeabilität der Klebemasse.

## Patentansprüche

1. Wasserdampfsperrende Klebemasse, enthaltend
eine Klebstoffbasis aus
- mindestens einem Reaktivharz
- mindestens einem Polymer, insbesondere einem Elastomer
- optional mindestens einem Klebharz,
- optional einem Lösungsmittel,
**dadurch gekennzeichnet, dass** die Klebemasse
mindestens ein multifunktionelles oligomeres Alkoxysiloxan enthält, wobei das oligomere Alkoxysiloxan mehr als eine polymerisierbare Gruppe und mehr als eine Alkoxygruppe enthält.

2. Wasserdampfsperrende Klebemasse nach Anspruch 1, **dadurch gekennzeichnet, dass** die Klebstoffbasis eine Wasserdampfpermeationsrate nach der Aktivierung der Reaktivharzkomponente von weniger als 100 g/m²d, bevorzugt von weniger als 50 g/m²d, insbesondere weniger als 15 g/m²d aufweist.

3. Wasserdampfsperrende Klebemasse nach Anspruch 1 oder 2, **dadurch gekennzeichnet, dass** das mindestens eine Alkoxysiloxan eine Verbindung der allgemeinen Formel 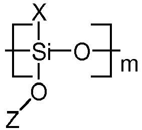
1 < m < 40
ist, wobei X ein Rest mit polymerisierbarer Gruppe, ausgewählt aus cyclischem Ether, Vinyl, Acrylat, Methacrylat, Hydroxyl, Amino und Isocyanat ist;
Z eine Alkyl- oder Arylgruppe ist,
wobei der Rest X der verschiedenen Wiederholungseinheiten gleich oder verschieden sein kann
wobei der Rest Z der verschiedenen Wiederholungseinheiten gleich oder verschieden sein kann.

4. Wasserdampfsperrende Klebemasse nach einem der Ansprüche 1 bis 3, **dadurch gekennzeichnet, dass** die Menge an Reaktivharz 15 bis 80 Gew.-%, insbesondere 20 bis 70 Gew.-%, besonders bevorzugt 25 bis 65 Gew.-% beträgt.

5. Wasserdampfsperrende Klebemasse nach einem der Ansprüche 1 bis 4, **dadurch gekennzeichnet, dass** das Reaktivharz als polymerisierbare Gruppe mindestens eine Gruppe, ausgewählt aus der Gruppe enthaltend Acrylate, Methacrylate cyclische Ether, insbesondere aliphatische und besonders bevorzugt cycloaliphatische Epoxide oder Oxetane, enthält.

6. Wasserdampfsperrende Klebemasse nach einem der Ansprüche 1 bis 5, **dadurch gekennzeichnet, dass** die Klebemasse haftklebrig ist.

7. Wasserdampfsperrende Klebemasse nach einem der Ansprüche 1 bis 6, **dadurch gekennzeichnet, dass** die Klebemasse kationisch, und zwar bevorzugt thermisch oder strahleninduziert, ausgehärtet wird.

8. Wasserdampfsperrende Klebemasse nach einem der Ansprüche 1 bis 7, **dadurch gekennzeichnet, dass** die Klebemasse einen Photoinitiator enthält.

9. Wasserdampfsperrende Klebemasse nach einem der Ansprüche 1 bis 8, **dadurch gekennzeichnet, dass** die polymerisierbare Gruppe des multifunktionellen Alkoxysiloxans mindestens eine Gruppe, ausgewählt aus der Gruppe bestehend aus cyclischer Ether, Acrylat, Methacrylat und Vinyl ist.

10. Wasserdampfsperrende Klebemasse nach einem der Ansprüche 1 bis 9, **dadurch gekennzeichnet, dass** das mindestens eine Elastomer mindestens ein Vinylaromatenblockcopolymer ist.

11. Klebeband enthaltend eine Klebemasse nach einem der Ansprüche 1 bis 10

12. Verwendung der Klebemasse nach einem der Ansprüche 1 bis 10 oder des Klebebandes nach Anspruch 11 zur Verkapselung von Aufbauten in der organischen Elektronik.

13. Verfahren zum Schutz einer auf einem Substrat angeordneten organischen elektronischen Anordnung,
wobei eine Abdeckung derart auf die elektronische Anordnung aufgebracht wird,
dass die elektronische Anordnung zumindest teilweise durch die Abdeckung überdeckt wird,
wobei weiterhin die Abdeckung zumindest teilflächig auf dem Substrat und/oder auf der elektronischen Anordnung verklebt wird,
wobei die Verklebung mittels zumindest einer Schicht einer Klebemasse nach zumindest einem der vorherigen Ansprüche bewirkt wird.

14. Verfahren nach Anspruch 13,
**dadurch gekennzeichnet, dass**
die Klebemasse als Schicht eines Klebebands vorliegt.

15. Verfahren nach zumindest einem der vorherigen Ansprüche,
**dadurch gekennzeichnet, dass**
zunächst die Klebemasseschicht, gegebenenfalls als Bestandteil eines weitere Schichten umfassenden doppelseitig klebenden Klebebandes, und in einem nachfolgenden Schritt die Abdeckung auf das Substrat und/oder die elektronische Anordnung aufgebracht wird.

16. Verfahren nach zumindest einem der vorherigen Ansprüche,
**dadurch gekennzeichnet, dass**
die Klebemasseschicht und die Abdeckung gemeinsam auf das Substrat und/oder die elektronische Anordnung aufgebracht werden.

17. Verfahren nach zumindest einem der vorherigen Ansprüche,
**dadurch gekennzeichnet, dass**
die Abdeckung die elektronische Anordnung vollständig überdeckt.

18. Verfahren nach zumindest einem der vorherigen Ansprüche,
**dadurch gekennzeichnet, dass**
auch ein Bereich des Substrats um die elektronische Anordnung herum durch die Abdeckung ganz oder teilweise überdeckt wird.

## Claims

1. Adhesive having water vapour barrier properties, comprising
an adhesive base composed of
- at least one reactive resin
- at least one polymer, especially an elastomer
- optionally at least one tackifying resin,
- optionally a solvent,
**characterized in that** the adhesive comprises
at least one multifunctional oligomeric alkoxysiloxane, said oligomeric alkoxysiloxane containing more than one polymerizable group and more than one alkoxy group.

2. Adhesive having water vapour barrier properties according to Claim 1, **characterized in that** the adhesive base has a water vapour permeation rate after the activation of the reactive resin component of less than 100 g/m²d, preferably of less than 50 g/m²d, especially less than 15 g/m²d.

3. Adhesive having water vapour barrier properties according to Claim 1 or 2, **characterized in that** the at least one alkoxysiloxane is a compound of the general formula 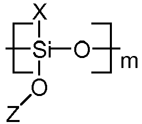
1 < m < 40,
where X is a radical having a polymerizable group selected from cyclic ether, vinyl, acrylate, methacrylate, hydroxyl, amino and isocyanate;
Z is an alkyl or aryl group,
where the X radicals of the different repeat units may be the same or different,
where the Z radicals of the different repeat units may be the same or different.

4. Adhesive having water vapour barrier properties according to any of Claims 1 to 3, **characterized in that** the amount of reactive resin is 15% to 80% by weight, especially 20% to 70% by weight, more preferably 25% to 65% by weight.

5. Adhesive having water vapour barrier properties according to any of Claims 1 to 4, **characterized in that** the reactive resin contains, as polymerizable group, at least one group selected from the group comprising acrylates, methacrylates, cyclic ethers, especially aliphatic and more preferably cycloaliphatic epoxides or oxetanes.

6. Adhesive having water vapour barrier properties according to any of Claims 1 to 5, **characterized in that** the adhesive is a pressure-sensitive adhesive.

7. Adhesive having water vapour barrier properties according to any of Claims 1 to 6, **characterized in that** the adhesive is cured by cationic means, and preferably by thermal or radiation-induced means.

8. Adhesive having water vapour barrier properties according to any of Claims 1 to 7, **characterized in that** the adhesive comprises a photoinitiator.

9. Adhesive having water vapour barrier properties according to any of Claims 1 to 8, **characterized in that** the polymerizable group of the multifunctional alkoxysiloxane is at least one group selected from the group consisting of cyclic ether, acrylate, methacrylate and vinyl.

10. Adhesive having water vapour barrier properties according to any of Claims 1 to 9, **characterized in that** the at least one elastomer is at least one vinylaromatic block copolymer.

11. Adhesive tape comprising an adhesive according to any of Claims 1 to 10.

12. Use of the adhesive according to any of Claims 1 to 10 or of the adhesive tape according to Claim 11 for encapsulation of assemblies in organic electronics.

13. Method for protecting an organic electronic arrangement disposed on a substrate, wherein a cover is applied to the electronic arrangement in such a way that the electronic arrangement is at least partly covered by the cover,
wherein the cover is additionally bonded over at least part of the area on the substrate and/or on the electronic arrangement,
wherein the bonding is brought about by means of at least one layer of an adhesive according to at least one of the preceding claims.

14. Method according to Claim 13,
**characterized in that**
the adhesive takes the form of a layer of an adhesive tape.

15. Process according to at least one of the preceding claims,
**characterized in that**
the adhesive layer, optionally as a constituent of a double-sided adhesive tape comprising further layers, is applied first, and in a subsequent step the cover is applied to the substrate and/or the electronic arrangement.

16. Process according to at least one of the preceding claims,
**characterized in that**
the adhesive layer and the cover are applied together to the substrate and/or the electronic arrangement.

17. Process according to at least one of the preceding claims,
**characterized in that**
the cover fully covers the electronic arrangement.

18. Process according to at least one of the preceding claims,
**characterized in that**
a region of the substrate around the electronic arrangement is also wholly or partly covered by the cover.

## Revendications

1. Matière adhésive pare-vapeur d'eau, contenant une base d'adhésif à base
- d'au moins une résine réactive
- au moins un polymère, en particulier un élastomère
- en option au moins une résine adhésive,
- en option un solvant,
**caractérisée en ce que** la matière adhésive
contient au moins un alcoxysiloxane oligomère multifonctionnel, l'alcoxysiloxane oligomère contenant plus d'un groupe apte à la polymérisation et plus d'un groupe alcoxy.

2. Matière adhésive pare-vapeur d'eau selon la revendication 1, **caractérisée en ce que** la base d'adhésif présente une vitesse de perméation de vapeur d'eau, après l'activation du composant résine réactive, de moins de 100 g/m²d, de préférence de moins de 50 g/m²/d, en particulier de moins de 15 g/m²/d.

3. Matière adhésive pare-vapeur d'eau selon la revendication 1 ou 2, **caractérisée en ce que** ledit au moins un alcoxysilane est un composé de formule générale 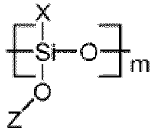
1 < m < 40
dans laquelle X est un radical à groupe apte à la polymérisation, choisi parmi un éther cyclique, les groupes vinyle, acrylate, méthacrylate, hydroxy, amino et isocyanate ;
Z est un groupe alkyle ou aryle,
le radical X des différents motifs répétitifs pouvant être le même ou différent
le radical Z des différents motifs répétitifs pouvant être le même ou différent.

4. Matière adhésive pare-vapeur d'eau selon l'une quelconque des revendications 1 à 3, **caractérisée en ce que** la quantité de résine réactive vaut de 15 à 80 % en poids, en particulier de 20 à 70 % en poids, de façon particulièrement préférée de 25 à 65 % en poids.

5. Matière adhésive pare-vapeur d'eau selon l'une quelconque des revendications 1 à 4, **caractérisée en ce que** la résine réactive contient en tant que groupe apte à la polymérisation au moins un groupe choisi dans le groupe contenant des acrylates, des méthacrylates, des éthers cycliques, en particulier des époxydes ou oxétanes aliphatiques et de façon particulièrement préférée cycloaliphatiques.

6. Matière adhésive pare-vapeur d'eau selon l'une quelconque des revendications 1 à 5, **caractérisée en ce que** la matière adhésive est autoadhésive.

7. Matière adhésive pare-vapeur d'eau selon l'une quelconque des revendications 1 à 6, **caractérisée en ce que** la matière adhésive est durcie par voie cationique, à savoir de préférence en étant induite thermiquement ou par irradiation.

8. Matière adhésive pare-vapeur d'eau selon l'une quelconque des revendications 1 à 7, **caractérisée en ce que** la matière adhésive contient un photoamorceur.

9. Matière adhésive pare-vapeur d'eau selon l'une quelconque des revendications 1 à 8, **caractérisée en ce que** le groupe apte à la polymérisation de l'alcoxysiloxane multifonctionnel est au moins un groupe choisi dans le groupe constitué par des éthers cycliques, les groupes acrylate, méthacrylate et vinyle.

10. Matière adhésive pare-vapeur d'eau selon l'une quelconque des revendications 1 à 9, **caractérisée en ce que** ledit au moins un élastomère est au moins un copolymère séquencé de composés vinylaromatiques.

11. Ruban adhésif contenant une matière adhésive selon l'une quelconque des revendications 1 à 10.

12. Utilisation de la matière adhésive selon l'une quelconque des revendications 1 à 10, ou du ruban adhésif selon la revendication 11, pour l'encapsulation de montages dans l'électronique organique.

13. Procédé pour la protection d'un assemblage électronique organique disposé sur un substrat,
dans lequel on applique un recouvrement sur l'assemblage électronique de telle sorte que l'assemblage électronique est au moins en partie recouvert par le recouvrement,
dans lequel en outre on colle le recouvrement au moins sur une partie de sa surface sur le substrat et/ou sur l'assemblage électronique,
en réalisant le collage à l'aide d'au moins une couche d'une matière adhésive selon au moins l'une quelconque des revendications précédentes.

14. Procédé selon la revendication 13,
**caractérisé en ce que**
la matière adhésive se trouve sous forme de couche d'un ruban adhésif.

15. Procédé selon au moins l'une quelconque des revendications précédentes,
**caractérisé en ce que**
d'abord on applique la couche de matière adhésive, éventuellement en tant que partie composante d'un ruban adhésif collant sur les deux faces, comprenant d'autres couches, et dans une étape subséquente on applique le recouvrement sur le substrat et/ou sur l'assemblage électronique.

16. Procédé selon au moins l'une quelconque des revendications précédentes,
**caractérisé en ce**
**qu'**on applique ensemble la couche de matière adhésive et le recouvrement sur le substrat et/ou l'assemblage électronique.

17. Procédé selon au moins l'une quelconque des revendications précédentes,
**caractérisé en ce que**
le recouvrement recouvre totalement l'assemblage électronique.

18. Procédé selon au moins l'une quelconque des revendications précédentes,
**caractérisé en ce**
**qu'**une partie du substrat autour de l'assemblage électronique est également partiellement ou totalement recouverte par le recouvrement.
